# EUROPEAN PATENT SPECIFICATION

(11) **EP 3 070 186 B1**
(45) Date of publication and mention of the grant of the patent: **04.09.2019**
(21) Application number: 14861969.5
(22) Date of filing: 14.11.2014
(51) Int. Cl.: C23C 22/60, B32B 15/18, C23C 22/42, C23C 22/83

(54) **CHEMICAL CONVERSION TREATMENT SOLUTION AND CHEMICALLY CONVERTED STEEL SHEET**
LÖSUNG ZUR CHEMISCHEN UMWANDLUNGBEHANDLUNG UND CHEMISCH UMGEWANDELTES STAHLBLECH
SOLUTION DE TRAITEMENT DE CONVERSION CHIMIQUE ET TÔLE D'ACIER CHIMIQUEMENT CONVERTIE

(30) Priority: 14.11.2013 JP 2013235543
(43) Date of publication of application: 21.09.2016
(73) Proprietor: NIPPON STEEL NISSHIN CO., LTD., Chiyoda-ku Tokyo 100-8366 (JP)
(72) Inventor: IWAMIZU, Yoshiharu, Tokyo 100-8366 (JP); SHIMIZU, Atsuo, Tokyo 100-8366 (JP); MATSUNO, Masanori, Tokyo 100-8366 (JP); YAMAMOTO, Masaya, Tokyo 100-8366 (JP)
(74) Representative: Epping - Hermann - Fischer
(86) International application number: PCT/JP2014/005750
(87) International publication number: WO 2015/072154

(56) References cited:
- EP-A1- 2 458 032
- JP-A- 2003 277 945
- JP-A- 2005 146 340
- JP-A- 2005 226 155
- JP-A- 2005 226 155

## Description

### Technical Field

The present invention relates to a chemically treated steel sheet, and a chemical treatment solution for a zinc-based plated steel sheet.

### Background Art

Zinc-based plated steel sheets have been used in wide applications such as automobiles, building materials, and home electric appliances. Typically, the surface of a plated steel sheet is subjected to a chromium-free chemical treatment for imparting corrosion resistance without oiling. The chromium-free chemical treatment is roughly divided into organic treatments and inorganic treatments. The organic treatments allow a thick film containing an organic resin to be formed, whereas the inorganic treatments allow a thin film (film thickness: 1 µm or less) to be formed for obtaining spot weldability. The organic treatments can impart relatively high corrosion resistance compared to the inorganic treatments. Some of the inorganic treatments also exhibit high corrosion resistance in the same degree as the organic treatments by using a zinc-based plated steel sheet containing aluminum and magnesium in its plating layer as an original sheet for chemical treatment.

As the inorganic treatment, for example, titanium-based, zirconium-based, molybdenum-based, and their complex-based inorganic treatments have been developed depending on the difference in corrosion inhibitors. Further, in order to enhance corrosion resistance, inorganic treatments to which a silane coupling agent, silica sol, an organic acid, or the like is further added have also been developed (see, e.g., PTLs 1 to 3).

PTL 1 discloses a chemically treated steel sheet obtained by forming a chromium-free chemical conversion film containing a valve metal and a soluble fluoride of the valve metal on the surface of a zinc-based plated steel sheet. PTL 2 discloses a chemically treated steel sheet obtained by forming a chromium-free chemical conversion film containing: a zirconium compound, a vanadyl compound (salt of VO²⁺), and the like; an organic acid; a silica compound; a fluoride; a lubricant; or the like on the surface of a Magnesium-Aluminum-Silicon-containing zinc-based plated steel sheet. PTL 3 discloses a chemically treated steel sheet obtained by forming a chromium-free chemical conversion film containing a basic zirconium compound, a vanadyl compound, a phosphate compound, a cobalt compound, an organic acid, or the like on the surface of a zinc-based plated steel sheet.

As disclosed in PTLs 1 to 3, chromium-free chemical treatments in which corrosion inhibitors are complexed, and an organic acid, a fluoride, a silane coupling agent, or the like is added for the enhancement of the functionality of the chromium-free chemical conversion film, and which can impart more excellent corrosion resistance of the film than that of the film obtained by the conventional chromate treatments. However, when the chemically treated steel sheet obtained by forming the chromium-free chemical conversion film on the surface of the zinc-based plated steel sheet is stored for a long period of time under high temperature and humid environment, the chemically treated steel sheet sometimes has a blacked surface of a plating layer due to oxidization. The blackening of the surface of the plating layer not only lowers the design but also cause adverse influences such as lowering of spot weldability. This phenomenon is remarkably apparent particularly in the zinc-based plated steel sheet containing aluminum and magnesium in its plating layer.

As a means for suppressing the blackening of the zinc-based plated steel sheet, PTL 4 proposes an organic chemical treatment in which a hexavalent molybdenum oxoate and an amine coexist. According to the technique of PTL 4, an amine forms a complex with molybdenum oxo-acid to suppress the reaction of the molybdenum oxoate with a zinc alloy plating layer, and thus a pentavalent or hexavalent molybdenum complex oxoate (so-called "molybdenum blue") is formed in the chemical conversion film. The pentavalent molybdenum oxoate in the chemical conversion film becomes the hexavalent molybdenum oxoate through the reaction with oxygen which permeates the film. In this manner, the pentavalent molybdenum oxoate in the chemical conversion film traps oxygen which permeates the film, so that the oxidation of the surface of the plating layer is suppressed, and as a result the blackening is also suppressed.

### Citation List

### Patent Literature

PTL 1
   Japanese Patent Application Laid-Open No. 2002-194558
PTL 2
   Japanese Patent Application Laid-Open No. 2003-055777
PTL 3
   WO2007/123276
PTL 4
   Japanese Patent Application Laid-Open No. 2005-146340

JP 2005-226155 (A) relates to a chemically-treated steel sheet, a plated steel sheet is used as a base material, a chemical film containing organic resin, a valve metal compound, ammonium salt and/or amines is formed on the surface of the base material, and the ratio of nitrogen (nitrogen ratio) composing an NCO group to the total nitrogen in the chemical film is controlled in the range of 0.8 to 0.95. As the valve metal compound, the oxide, hydroxide, fluoride or the like of Ti, Zr, Hf, V, Nb, Mo, W, Si, Al or the like are given, and, preferably, at least one kind is oxoate having oxidizing properties.

### Summary of Invention

### Technical Problem

In order to impart high corrosion resistance to a chemically treated steel sheet, it is necessary to dry a chemical treatment solution applied to the surface of the steel sheet sufficiently to form an insoluble film. When the drying temperature is low and drying is insufficient, corrosion resistance is remarkably lowered. Therefore, when the chemically treated steel sheet is produced in a continuous line, it is necessary to dry the chemical treatment solution at a high temperature of a steel sheet temperature of about 50 to 200°C, from the viewpoint of both achieving sufficient drying and productivity.

Recently, CO₂ elimination as a countermeasure for global warming and power saving as a countermeasure for power shortage have been required. In particular, in order to cope with Scope 3, products have been required, which contribute to CO₂ elimination even in the stage in which raw materials for the products are produced. Accordingly, also in the chromium-free chemical treatment, it has been required to lower the drying temperature and reduce the drying time.

The present invention has been achieved in light of the above-mentioned respects, and an object of the present invention is to provide a chemically treated steel sheet which is excellent in corrosion resistance and blackening resistance obtained by employing a zinc-based plated steel sheet as an original sheet, and which is capable of being produced even when an applied chemical treatment solution is dried at a low temperature and for a short period of time.

Another object of the present invention is to provide a chemical treatment solution capable of forming a chemical conversion film that enhances corrosion resistance and blackening resistance even when being dried at a low temperature and for a short period of time.

### Solution to Problem

The above objects are achieved by providing a chemical treatment solution according to claim 1 and a chemically treated steel sheet according to claim 2. Preferred embodiments are set forth in the dependent claims.

The present inventors have studied the chromium-free chemical treatment for the zinc-based plated steel sheet in terms of the relationship between treatment conditions (such as the composition of the chemical conversion film and drying temperature) and various quality properties. As a result, the present inventors have found it important to form an insoluble complex film with small residual amount of a soluble salt and a solvent, for the enhancement of corrosion resistance. That is, it has been found that, when excessive amounts of a fluoride, an organic acid, and an amine with a high-boiling point remain in the chemical conversion film, corrosion resistance is remarkably lowered. Particularly, it has been found that, the composition of the chemical treatment solution is quite important, because when the chemical treatment solution is dried at a low temperature and for a short period of time, a complex salt is less likely to be formed, and a fluoride, an organic acid, and an amine with a high-boiling point tend to remain.

As a result of intensive study in consideration of those respects, the present inventors have found that the above-described problems can be solved by forming a chemical conversion film using a chemical treatment solution according to claim 1, and have studied further to complete the present invention.

That is, the present invention relates to the following chemical treatment solution: A chemical treatment solution for coating a zinc-based plated steel sheet having a zinc-based plating layer containing 0.1 to 22.0 mass % of aluminum, the chemical treatment solution containing a molybdenum acid ion, pentavalent vanadium ion, an amine, an oxoate of group 4 element and a phosphate selected from the group consisting of a diammonium hydrogen phosphate, an ammonium dihydrogen phosphate, and triammonium phosphate, in which the amine has a molecular weight of 80 or less, a molar ratio of molybdenum to vanadium in the chemical treatment solution is 0.4 to 5.5, a molar ratio of the amine to the vanadium in the chemical treatment solution is 0.3 or more, a content of a hydrophilic resin in the chemical treatment solution is at most 100 mass % based on a total amount of the vanadium and the molybdenum in the chemical treatment solution, a total content of fluorine derived from a fluorine ion or a fluorometal ion in the chemical treatment solution is at most 30 mass % based on the total amount of the vanadium and the molybdenum in the chemical treatment solution, and a content of silicon derived from a silanol group in the chemical treatment solution is at most 50 mass % based on the total amount of the vanadium and the molybdenum in the chemical treatment solution. The chemical treatment solution comprises an amine, in which the amine has a molecular weight of 80 or less.

Further, the present invention relates to the following chemically treated steel sheet: A chemically treated steel sheet, formed by applying the chemical treatment solution according to claim 1 to the surface of a zinc-based steel sheet and drying the same, including a zinc-based plated steel sheet having a zinc-based plating layer containing 0.1 to 22.0 mass % of aluminum, and a chemical conversion film disposed on the zinc-based plating layer, in which the chemical conversion film includes a first chemical conversion layer disposed on a surface of the zinc-based plating layer and containing vanadium, molybdenum and phosphorus, and a second chemical conversion layer disposed on the first chemical conversion layer and containing an oxoate of group 4 element, and a percentage of pentavalent vanadium based on mixed-valent vanadium in the chemical conversion film
is 0.7 or more. The chemically treated steel sheet according to claim 2, in which the oxoate of group 4 element is a zirconium oxoate, and the chemical conversion film contains 1 to 60 parts by mass of molybdenum, 2 to 20 parts by mass of vanadium, and 10 to 50 parts by mass of phosphorus, based on 100 parts by mass of zirconium.

The chemically treated steel sheet according to claim 2 or claim 3, in which the zinc-based plated steel sheet is a hot-dip aluminum- and magnesium-containing zinc plated steel sheet having a hot-dip aluminum- and magnesium-containing zinc plating layer containing 0.1 to 22.0 mass % of aluminum and 1.5 to 10.0 mass % of magnesium.

### Advantageous Effects of Invention

According to the present invention, it is possible to produce a chemically treated steel sheet excellent in corrosion resistance and blackening resistance even when a chemical treatment solution applied to the surface of a zinc-based plated steel sheet is dried at a low temperature and for a short period of time.

### Brief Description of Drawings

FIG. 1 is a TEM image of a cross-section of a test specimen of one example of a chemically treated steel sheet according to the present invention produced at a drying temperature of 80°C;
FIG. 2 is a diagram showing an element distribution of the test specimen from the surface thereof toward the depth direction; and
FIG. 3 is a diagram showing the intensity profile of chemical binding energy corresponding to 2p orbit of vanadium in an interface between a chemical conversion film and plating layer interface of a test specimen of the other example of the chemically treated steel sheet according to the present invention.

### Description of Embodiments

A chemically treated steel sheet of the present invention includes a zinc-based plated steel sheet (original sheet for chemical treatment) and a chemical conversion film formed on a surface of the zinc-based plated steel sheet. Hereinafter, each constituent element will be described.

### [Zinc-Based Plated Steel Sheet]

As the original sheet for chemical treatment, a zinc-based plated steel sheet excellent in corrosion resistance and design is used. As used herein, the term "zinc-based plated steel sheet" means a plated steel sheet having a zinc-based plating layer containing 0.1 to 22.0 mass % of aluminum and 50 mass % or more of zinc. Examples of the zinc-based plated steel sheet include hot-dip zinc plated steel sheet (GI), alloyed hot-dip zinc plated steel sheet (GA), hot-dip zinc-aluminum plated steel sheet, and hot-dip zinc-aluminum-magnesium plated steel sheet. The plating layers of the hot-dip zinc plated steel sheet (GI) and alloyed hot-dip zinc plated steel sheet (GA) also contain 0.1 mass % or more of aluminum for preventing oxidation. The zinc-based plated steel sheet may be produced by a hot-dip plating process, an electroplating process, a vapor-deposition plating process, or the like.

For example, the hot-dip zinc-aluminum-magnesium plated steel sheet can be produced by the hot-dip plating process using an alloy plating bath containing 1.0 to 22.0 mass % of aluminum and 1.5 to 10.0 mass % of magnesium, with the residual part being substantially zinc. In order to enhance the adherence between a steel substrate and a plating layer, silicon which suppresses the growth of an aluminum-iron alloy layer in the interface between the steel substrate and the plating layer may be added to the plating bath in a range of 0.005 to 2.0 mass %. Further, in order to suppress the generation and the growth of Zn₁₁Mg₂ phase which causes adverse influence on its outer appearance and corrosion resistance, titanium, boron, a titanium-boron alloy, a titanium-containing compound or a boron-containing compound may be added to the plating bath. The addition amounts of these compounds are preferably set such that titanium is within a range of 0.001 to 0.1 mass % and boron is within a range of 0.0005 to 0.045 mass %.

The type of the steel substrate of the zinc-based plated steel sheet is not particularly limited. Examples of the steel substrate include common steel, low alloy steel, and stainless steel.

### [Chemical Conversion Film]

A chemical conversion film is formed on the surface of the zinc-based plated steel sheet. The chemical conversion film enhances the corrosion resistance and blackening resistance of the zinc-based plated steel sheet. The chemical conversion film includes a first chemical conversion layer (reaction layer) positioned on the surface of the zinc-based plated steel sheet and principally composed of vanadium, molybdenum and phosphorus, and a second chemical conversion layer positioned on the first chemical conversion layer and principally composed of an oxoate of group 4 element.

As used herein, the term "corrosion resistance" includes one or both of flat part corrosion resistance and worked part corrosion resistance. "Worked part corrosion resistance" is corrosion resistance of a part subjected to working (working part) such as bending work in which a chemically treated steel sheet is deformed, and "flat part corrosion resistance" is corrosion resistance of a part other than the working part in the chemically treated steel sheet.

### [Chemical Treatment Solution]

The chemical conversion film is formed by applying and drying an alkaline chemical treatment solution according to claim 1. By adjusting the pH of the chemical treatment solution to be alkaline, it is possible to form the first chemical conversion layer (reaction layer) without using fluorine even on an aluminum part of the surface of the plating layer having less reactivity. By using the chemical treatment solution of such a composition, it becomes possible to form a chemical conversion film which may enhance the corrosion resistance and blackening resistance of the zinc-based plated steel sheet, even when the chemical treatment solution is dried at a low temperature and for a short period of time. The vanadium derived from the pentavalent vanadium ion, molybdenum derived from molybdenum acid ion and phosphorus derived from the phosphate are localized in the first chemical conversion layer. Further, the oxoate of group 4 element is localized in the second chemical conversion layer. Hereinafter, each element contained in the chemical treatment solution will be described.

### 1) Molybdenum acid ion

A molybdate stabilizes the valence of vanadium in the chemical treatment solution, and enhances the blackening resistance and corrosion resistance of the chemically treated steel sheet. It is deduced that a molybdenum acid ion (hereinafter, also referred to as Mo acid ion) forms a complex with a pentavalent vanadium ion (hereinafter, also referred to as pentavalent V ion) in the alkaline chemical treatment solution to thereby stabilize the valence of vanadium so as to be pentavalent.

The molar ratio of molybdenum to vanadium in the chemical treatment solution, i.e., the molar ratio of a molybdenum element derived from a molybdate to a vanadium element derived from a pentavalent vanadium ion (Mo/V) in the chemical treatment solution is within a range of 0.4 to 5.5. When the molar ratio of the molybdenum element to the vanadium element is less than 0.4, there is a concern that the valence of vanadium cannot be kept to be pentavalent. When the molar ratio of the molybdenum element to the vanadium element is more than 5.5, a Mo acid ion is more likely to form a condensed acid, and the Mo acid ion that forms a complex with the pentavalent V ion becomes insufficient, so that there is a concern that the valence of V may not be stable.

Further, when a chemical conversion film is formed using a chemical treatment solution in which a molybdenum acid ion and an amine coexist, a pentavalent or hexavalent molybdenum complex oxoate is formed in the chemical conversion film.

When a chemical conversion film is formed, in an alkaline condition, using the chemical treatment solution in which a pentavalent vanadium ion, a molybdenum acid ion and an amine coexist, molybdenum preferentially reacts with the surface of the plating layer together with the pentavalent vanadium ion and phosphorus to form a first chemical conversion layer (reaction layer) on the surface of the plating layer. In this manner, the molybdenum acid ion forms a uniform reaction layer on the surface of the plating layer together with pentavalent vanadium ion and the phosphorus, and thus blackening resistance is enhanced. Further, due to the coexistence of the molybdenum acid ion and the amine, a pentavalent or hexavalent molybdenum complex oxoate is formed in the chemical conversion film, which pentavalent molybdenum oxoate is oxidized to thereby form an oxidized film; the oxidized film also contributes to the enhancement of corrosion resistance. In addition, when the above-described lattice defect occurs, the plating layer is considered to exhibit a gray outer appearance with metal luster being suppressed further due to more absorption of light of a wavelength in visible region.

The type of the molybdenum acid ion is not particularly limited as long as the molybdenum acid ion can perform the above-mentioned functions. Examples of the molybdate include molybdenum acid, ammonium molybdate, and a molybdenum acid alkali metal salt. Among those, molybdenum acid or ammonium molybdate is particularly preferred from the viewpoint of corrosion resistance. The amount of molybdenum contained in the chemical conversion film is preferably within a range of 1 to 60 parts by mass based on 100 parts by mass of a group 4 metal (e.g., zirconium). When the amount of molybdenum is less than 1 part by mass, there is a concern that the blackening resistance cannot be sufficiently enhanced. When the amount of molybdenum is more than 60 parts by mass, the amount of a molybdate unreacted with the surface of the plating layer becomes excessive, so that there is a concern that working part corrosion resistance may be lowered.

### 2) Pentavalent vanadium ion

A pentavalent vanadium ion contributes not only to the enhancement of corrosion resistance but also to the enhancement of blackening resistance. When a chemical conversion film is formed, in an alkaline condition, using a chemical treatment solution in which a pentavalent vanadium ion, a molybdenum acid ion and an amine coexist, vanadium preferentially reacts with the surface of the plating layer together with molybdenum acid and phosphorus to form a first chemical conversion layer (reaction layer) on the surface of the plating layer. In this manner, vanadium forms a uniform reaction layer on the surface of the plating layer together with molybdenum acid and a group 4 metal, and thus corrosion resistance and blackening resistance are enhanced.

The type of the pentavalent vanadium ion is not particularly limited as long as the pentavalent vanadium ion can perform the above-mentioned functions. Examples of the pentavalent vanadium ion include ammonium metavanadate, sodium metavanadate, potassium metavanadate, and a vanadate obtained by dissolving vanadium pentoxide with an amine. In all of these vanadium compounds, the valence of vanadium is pentavalent (hereinafter, vanadium having a valence of 5 is also referred to as "pentavalent V"). Among those, ammonium metavanadate, or a vanadate obtained by dissolving vanadium pentoxide with an amine is particularly preferred from the viewpoint of corrosion resistance.

Generally, the pentavalent V ion in the chemical treatment solution has low stability of valence. Accordingly, if the pentavalent V ion in the chemical treatment solution is left alone, the concentration of the pentavalent V ion fails to reach a concentration at which the above-mentioned reaction layer is formed. Thus, as described above, the coexistence with the molybdate in an alkaline condition increases the concentration of the pentavalent V ion in the chemical treatment solution. Further, it is considered that the pentavalent V ion does not have higher solubility in the chemical treatment solution than a divalent to tetravalent vanadium ion chelated through reduction by an organic acid and thus is more likely to preferentially precipitate on the surface of the plating layer to generate a reaction.

The content of the pentavalent vanadium ion in the chemically treatment solution is preferably 8 g/L or less in terms of vanadium atom. When this content is more than 8 g/L, the stability of the chemical treatment solution is lowered, so that there is a possibility of the formation of a precipitate when the chemical treatment solution is stored at room temperature for about a month. In this connection, in a case where the chemical treatment solution is used immediately after the production thereof, the above-mentioned problem of stability does not occur even when the above-mentioned content is more than 8 g/L.

The amount of vanadium contained in the chemical treatment solution is preferably within a range of 2 to 20 parts by mass based on 100 parts by mass of a group 4 metal (e.g., zirconium). When the amount of vanadium is less than 2 parts by mass, there is a concern that the corrosion resistance and blackening resistance cannot be enhanced sufficiently. When the amount of vanadium is more than 20 parts by mass, there is a concern that the amount of pentavalent vanadium unreacted with the surface of the plating layer may become excessive, causing the corrosion resistance to be lowered.

The percentage of pentavalent vanadium based on mixed-valent vanadium in the chemical conversion film is 0.7 or more. When the percentage of pentavalent vanadium based on mixed-valent vanadium is less than 0.7, there is a concern that the blackening resistance cannot be enhanced sufficiently.

### 3) Amine

An amine dissolves a compound containing pentavalent vanadium ion (hereafter, also referred to as "pentavalent vanadium salt") in the chemical treatment solution while keeping the valence of vanadium to be pentavalent (tetravalent when an organic acid is used), and also forms a pentavalent or hexavalent molybdenum complex oxoate from a molybdate. The amine is preferably an amine having a low boiling point. The amine having a low boiling point is an amine having a molecular weight of 80 or less. The amine having a molecular weight of 80 or less generally has a low boiling point, and hardly remains in a chemical conversion film even when the chemical treatment solution is dried at a low temperature and for a short period of time, so that the amine can contribute to the enhancement of the corrosion resistance. Examples of the amine having a low boiling point include ammonia (used as aqueous ammonia), ethanolamine, 1-amino-2-propanol, and ethylenediamine. When an excessive amount of amine remains in the chemical conversion film after being dried, the corrosion resistance of a chemically treated steel sheet is undesirably lowered due to elution of an amine. Therefore, the amount of the amine remaining in the chemical conversion film is preferably 10 mass % or less in terms of nitrogen from the viewpoint of preventing the lowering of the corrosion resistance of the chemically treated steel sheet. By using an amine having a molecular weight of 80 or less, the amount of the remaining amine can be 10 mass % or less in terms of nitrogen.

By dissolving a pentavalent vanadium salt in a liquid amine or an aqueous amine solution, the pentavalent vanadium salt having low water-solubility can be blended into a chemical treatment solution while keeping the valence of vanadium to be pentavalent. When dissolving the pentavalent vanadium salt in a liquid amine, the addition of the resultant solution to the aqueous solution containing a molybdate enables a chemical treatment solution to be prepared. In addition, when dissolving the pentavalent vanadium salt in an aqueous amine solution, a pentavalent vanadium salt may be added after the molybdate and the amine to thereby directly prepare a chemical treatment solution, or a pentavalent vanadium salt may be dissolved in the aqueous amine solution, and then the resultant solution may be added to the aqueous solution containing a molybdate to prepared a chemical treatment solution. Typically, an aqueous solution containing tetravalent vanadium (V⁴⁺) is blue, whereas an aqueous solution containing pentavalent vanadium (V⁵⁺) is yellow, and thus it is possible to presume the valence of vanadium from the color of the chemical treatment solution.

As described above, when using a vanadate as a vanadium salt, vanadium pentoxide is dissolved in an amine to prepare a vanadate. At that time, heat is generated in dissolving pentavalent vanadium in an amine. There is a concern that the pentavalent vanadium may be reduced to tetravalent vanadium in a high temperature environment of 40°C or higher. Thus, in order to dissolve the pentavalent vanadium salt in an amine while keeping the valence of vanadium to be pentavalent, it is necessary to maintain an environmental temperature of the pentavalent vanadium less than 40°C. The method in which the environmental temperature is maintained less than 40°C is not particularly limited. For example, the addition of vanadium pentoxide to the amine solution (dilution of amine and vanadium pentoxide) can maintain the environmental temperature less than 40°C.

The molar ratio of the amine to vanadium in the chemical treatment solution is 0.3 or more. When this molar ratio is less than 0.3, there is a concern that the valence of vanadium cannot be kept to be pentavalent. The molar ratio of the amine to vanadium is preferably 10 or less from the viewpoints of not allowing the effect of maintaining the valence of vanadium to reach a plateau, and of suppressing the cost of amine.

### 4) Oxoate of group 4 element

A group 4 metal oxoate forms a dense chemical conversion film to enhance corrosion resistance. That is, while it is difficult to form a dense chemical conversion film with a chemical treatment solution containing only a molybdate and a vanadium salt, it is possible to form a chemical conversion film having a high barrier property by cross-linking molybdenum and vanadium with the further addition of the group 4 metal oxoate.

The type of the group 4 metal oxoate is not particularly limited. Examples of the group 4 metal oxoate include titanium, zirconium, and hafnium. Examples of the type of oxoate include hydracid salt, ammonium salt, alkaline metal salt, and alkaline earth metal salt. Among those, a group 4 metal oxoate ammonium salt is preferred, and ammonium zirconium carbonate is particularly preferred, from the viewpoint of corrosion resistance.

### 5) Phosphate

The chemical treatment solution further contains a phosphate. The phosphate functions with the group 4 metal oxoate to thereby form a dense chemical conversion film, thus enhancing corrosion resistance. The phosphate is selected from the group consisting of a diammonium hydrogen phosphate, ammonium dihydrogen phosphate, and triammonium phosphate, which can sufficiently enhance corrosion resistance, is preferred, even when being dried at a low temperature and for a short period of time. The amount of phosphorus in the chemical conversion film is preferably in a range of 10 to 50 parts by mass based on 100 parts by mass of the group 4 metal (e.g., zirconium). When the amount of phosphorus is less than 10 parts by mass, a crack which constitutes a defect is more likely to occur in the chemical conversion film, so that there is a concern that the corrosion resistance may be lowered. When the amount of phosphorus is more than 50 parts by mass, an unreacted phosphate remains in the chemical conversion film, so that there is a concern that the corrosion resistance may be lowered.

Noted that, when specific component used in the conventional chromium-free chemical treatment is added to the above-mentioned chemical treatment solution, the expected characteristics of the chemically treated steel sheet may be insufficient. For example, a certain type of organic resin, silane coupling agent, or organic acid is added, a pentavalent V ion is more likely to be reduced to a tetravalent vanadium ion, so that blackening resistance may be lowered. Further, a functional group having a polarity is adsorbed to the plating surface, and thus the formation of a reaction layer at that portion is inhibited, so that there is a concern that corrosion resistance may be lowered. This phenomenon may be also observed when a film-forming aid (solvent such as butyl cello solve) for forming a film from an aqueous organic resin at a low temperature is added. Thus, it is preferable for the chemical treatment solution of the present invention not to contain the organic acid, organic resin, silane coupling agent, and film-forming aid.

The above-mentioned specific components are not substantially contained in the chemical treatment solution. As used herein, the term "not substantially contained" means that "may be contained in such a range that the above-described effects of the present invention are achieved," and also means that "preferably not contained at all from the viewpoint of remarkably achieving the above-described effects of the present invention." Examples of the specific component include a hydrophilic resin, fluorine derived from a fluorine ion or a fluorometal ion, and silicon derived from a silanol group.

The hydrophilic resin is a resin dissolved or dispersed evenly in an aqueous medium, and contains a hydrophilic functional group in an amount enough to allow the resin to be dissolved or dispersed evenly in the aqueous medium. The hydrophilic resin may also be referred to as an aqueous resin. Either one type of the hydrophilic resin or two or more types thereof may be employed. Examples of the hydrophilic resin include a resin which is dissolved or evenly dispersed in an aqueous medium to increase the viscosity of the aqueous medium; more specific examples thereof include acrylic resin, a polyolefin, epoxy resin, and polyurethane, which have the hydrophilic functional group as necessary due to modification. Examples of the hydrophilic functional group include a hydroxyl group, a carboxyl group, and an amino group. Either one type of the hydrophilic functional group or two or more types thereof may be employed, as well.

Incidentally, on the surface of the zinc-based plated steel sheet, there exists a polar group which typically exists on the surface of a metal, such as a hydroxyl group. The above-mentioned reaction layer is considered to be formed through a specific interaction of the polar group with component which constitutes the reaction layer, such as molybdenum and vanadium in the chemical treatment solution.

Accordingly, it is considered that, when there exists a large amount of the hydrophilic resin in the chemical treatment solution, the hydrophilic functional group undergoes an interaction such as hydrogen bonding or dehydration condensation with the polar group on the surface of the zinc-based plated steel sheet, so that the polar group to interact with a component in the reaction layer becomes insufficient relative to the component in the reaction layer, and as a result the formation of the reaction layer is inhibited, causing the expected characteristics of the chemically treated steel sheet to be insufficient.

For the above-mentioned reasons, the acceptable content of the hydrophilic resin in the chemical treatment solution is at most 100 mass % (i.e., 100 mass % or less) based on the total amount of vanadium and molybdenum in the chemical treatment solution. When the content of the hydrophilic resin is more than 100 mass %, the formation of the reaction layer is inhibited, so that the expected functions such as corrosion resistance and blackening resistance in the chemically treated steel sheet may be insufficient. From the viewpoint of sufficiently exhibiting expected functions in the chemically treated steel sheet, the content of the hydrophilic resin is preferably as small as possible; for example, the content thereof is preferably 50 mass % or less, more preferably 20 mass % or less, and most preferably 0 mass %.

The fluorine derived from a fluorine ion or a fluorometal ion may exhibit etching actions on the surface of the zinc-based plated steel sheet to form a layer of a fluoride. Examples of the fluorine include F⁻ and MF₆²⁻. As used herein, "M" denotes a tetravalent metal element, for example, zirconium, titanium, or silicon. Examples of the above-mentioned component which serves as an origin of the fluorine include potassium fluoride (KF), ammonium titanium fluoride ((NH₄)₂TiF₆), and hydrofluosilicic acid (H₂SiF₆). Either one type of the fluorine or two or more types thereof may be employed.

It is considered that, when there exists a large amount of the fluorine in the chemical treatment solution, the surface of the zinc-based plated steel sheet is dissolved by the etching action of the fluorine, and the fluorine in the chemical treatment solution is concentrated on the dissolved portion, with a fluoride thin layer being formed on the surface of the zinc-based plated steel sheet, so that the polar group, which is exposed to the surface of the zinc-based plated steel sheet, to interact with the component in the reaction layer becomes insufficient relative to the component in the reaction layer, resulting in the inhibition of the formation of the reaction layer, causing the expected characteristics of the chemically treated steel sheet to be insufficient. Examples of the component that occurs due to the dissolution of the surface of the zinc-based plated steel sheet include Zn²⁺, Al³⁺, and Mg²⁺, and examples of the fluoride include ZnF₂, AlF₃, and MgF₂. It is noted that the fluoride can be confirmed on the chemically treated steel sheet by X-ray photoelectron spectroscopy (XPS).

For the above-mentioned reasons, the total content of the fluorine derived from a fluorine ion or a fluorometal ion in the chemical treatment solution is at most 30 mass % (i.e., 30 mass % or less) based on the total amount of vanadium and molybdenum in the chemical treatment solution. When the content of the fluorine is more than 30 mass %, the formation of the reaction layer may be inhibited, so that the expected functions such as corrosion resistance and blackening resistance in the chemically treated steel sheet may be insufficient. From the viewpoint of sufficiently exhibiting expected functions in the chemically treated steel sheet, the content of the fluorine is preferably as small as possible; for example, the content thereof is preferably 10 mass % or less, more preferably 5 mass % or less, and most preferably 0 mass %.

The silicon derived from a silanol group has a hydroxyl group. Accordingly, it is considered that, when the chemical treatment solution contains the silicon, the existence of the silicon derived from a silanol group inhibits the formation of the reaction layer, for the similar reason to those for the hydrophilic resin. That is, it is considered that, when there exists a large amount of the silicon in the chemical treatment solution, the hydrophilic group in the silanol group undergoes an interaction such as hydrogen bonding or dehydration condensation with the polar group on the surface of the zinc-based plated steel sheet, so that the polar group to interact with a component in the reaction layer becomes insufficient relative to the component in the reaction layer, and as a result the formation of the reaction layer is inhibited, causing the expected characteristics of the chemically treated steel sheet to be insufficient. Examples of the component which serves as an origin of the silicon include a silane coupling agent; more specific examples thereof include 3-aminopropyltrimethoxysilane, 3-glycidoxypropyltriethoxysilane, and vinylethoxysilane.

For the above-mentioned reasons, the content of the silicon derived from a silanol group in the chemical treatment solution is at most 50 mass % (i.e., 50 mass % or less) based on the total amount of vanadium and molybdenum in the chemical treatment solution. When the content of the silicon is more than 50 mass %, the formation of the reaction layer may be inhibited, so that the expected functions such as corrosion resistance and blackening resistance in the chemically treated steel sheet may be insufficient. From the viewpoint of sufficiently exhibiting expected functions in the chemically treated steel sheet, the content of the silicon is preferably as small as possible; for example, the content thereof is preferably 20 mass % or less, more preferably 10 mass % or less, and most preferably 0 mass %.

The existence and the content of the hydrophilic resin, fluorine, or silicon in the chemical treatment solution can be determined using known analyzers such as infrared spectroscopy (IR) spectrometer, nuclear magnetic resonance (NMR) spectrometer, inductively coupled plasma (ICP) emission analyzer, and fluorescent X-ray analyzer.

The method of identifying the structure of a chemical conversion film is not particularly limited. For example, it is possible to confirm that a chemical conversion film includes the first chemical conversion layer and the second chemical conversion layer, by observing the cross-section of a chemically treated steel sheet using a transmission electron microscope (TEM). Further, energy dispersive X-ray measurement (EDS) can be used to identify a component contained in each chemical conversion layer. Furthermore, glow discharge optical emission spectrometry (GDS) can be used to identify the distribution of each component. Moreover, X-ray photoelectron spectroscopy (XPS) can be used to identify the percentage of pentavalent vanadium based on the mixed-valent vanadium in the chemical conversion film.

### [Method of Formation of Chemical Conversion Film]

As described above, a chemical conversion film is formed by applying a chemical treatment solution containing the above-mentioned each component to the surface of a zinc-based plated steel sheet, and drying the same.

The application method of the chemical treatment solution is not particularly limited. Examples of the application method of the chemical treatment solution include roll coating method, spin coating method, and spray coating method. The deposition amount of the chemical treatment solution is preferably within a range of 50 to 1,000 mg/m². When the deposition amount is less than 50 mg/m², corrosion resistance cannot be sufficiently enhanced. When the deposition amount is more than 1,000 mg/m², corrosion resistance undesirably becomes excessive. Furthermore, taking account of spot weldability, the deposition amount of the chemical conversion film is more preferably within a range of 50 to 500 mg/m².

The drying temperature of the chemical treatment solution (a temperature of the sheet) may be an ordinary temperature, but is preferably 30°C or higher. The chemical treatment solution of the present invention can enhance corrosion resistance and blackening resistance even when being dried at a low temperature and for a long period of time. When the drying temperature exceeds 120°C, a crack undesirably occurs due to the volume shrinkage of the chemical conversion film as a result of, for example, rapid decomposition of ammonia components, so that there is a concern that the corrosion resistance of the chemically treated steel sheet may be lowered. Therefore, the drying temperature of the chemical treatment solution is within a range of preferably 30 to 120°C, and more preferably 35 to 85°C.

As described above, the chemical treatment solution according to claim 1 contains the above-mentioned components, and the molybdate and amine are contained at the above-mentioned specific ratio to the vanadium salt. In addition, the chemical treatment solution of the present invention neither contains the above-mentioned hydrophilic resin, nor fluorine derived from a fluorine ion or a fluorometal ion, nor silicon derived from a silanol group, or alternatively only contains these elements up to the above-mentioned specific acceptable amount. Since such a chemical treatment solution is used for production, the chemically treated steel sheet of the present invention includes a zinc-based plated steel sheet, vanadium, molybdenum, phosphorus, and a group 4 metal oxoate, and including a two-layer structure of the first chemical conversion layer and the second chemical conversion layer. Therefore, the chemically treated steel sheet of the present invention is excellent in corrosion resistance and blackening resistance even when the chemical treatment solution is dried at a low temperature and for a short period of time.

Hereinafter, the present invention will be explained in detail with reference to Examples, which however shall not be construed as limiting the scope of the invention thereto.

### Examples

### [Production of Zinc-Based Plated Steel Sheet]

A steel strip of ultra-low carbon titanium-added steel having a sheet thickness of 0.5 mm was used as the substrate steel to produce a hot-dip zinc alloy plated steel sheet having a zinc-based layer containing 6 mass % of aluminum, 3 mass % of magnesium, 0.020 mass % of silicon, 0.020 mass % of titanium, and 0.0005 mass % of boron (plating deposition amount of 90 g/m² per side), in a continuous hot-dip zinc plating production line, and the produced zinc alloy plated steel sheet was used as the original sheet for chemical treatment.

### [Example 1]

A water-soluble molybdenum salt, a vanadium salt, an amine, a group 4 metal oxoate, and a phosphate, which are shown in Table 1, were dissolved in water to prepare chemical treatment solutions 1 to 50. The name and symbol of each compound added to the chemical treatment solution are shown in Table 1. The composition and color of each chemical treatment solution are shown in Tables 2-1, 2-2, 3-1, 3-2, 4-1 and 4-2. Note that the dissolution of the vanadium salt was performed in an aqueous solution having a liquid temperature of 40°C or lower containing an amine for preventing vanadium from being reduced.

EDTA and NH in table 1 are not representing an amine and the examples in tables 2-1, 3-1, 4-1, 5-1 and 6-1 containing EDTA and NH are reference examples;

P4 and P5 in table 1 are not representing phosphate compounds and the examples in tables 2-2, 3-2, 4-2, 5-2 and 6-2 containing P4 and P5 are reference examples.

**Table 1**

| Type | Symbol | Compound Name | Chemical Formula | Molecular Weight |
|---|---|---|---|---|
| Molybdate | M1 | Ammonium Molybdate | (NH₄)₆Mο₇O₂₄·4H₂O | - |
| Vanadium Salt | V1 | Vanadium Pentoxide | V₂O₅ | - |
| | V2 | Ammonium Metavanadate | NH₄VO₃ | - |
| | V3 | Sodium Metavanadate | NaVO₃ | - |
| Amine | EA | Ethanolamine | C₂H₇NO | 61 |
| | DEA | Diethanolamine | C₄H₁₁NO₂ | 105 |
| | IPA | 1-Amino-2-Propanol | C₃H₉NO | 75 |
| | TMAH | Tetramethylammonium hydroxide | (CH₃)₄N⁺OH⁻ | 91 |
| | EDTA | Ethylenediaminetetraacetic Acid | (HOOCCH₂)₂NCH₂CH₂N(CH₂COOH)₂ | 292 |
| | EN | Ethylenediamine | NH₂CH₂CH₂NH₂ | 60 |
| | NH | Aqueous Ammonia | NH₄OH | 35 |
| Group 4A Oxoate | A1 | Ammonium Zirconium Carbonate | (NH₄)₂Zr(OH)₂(CO₃)₂ | - |
| Phosphate | P1 | Diammonium Hydrogen Phosphate | (NH₄)₂HPO₄ | - |
| | P2 | Ammonium Dihydrogen Phosphate | NH₄H₂PO₄ | - |
| | P3 | Triammonium Phosphate | (NH₄)₃PO₄ | - |
| | P4 | Phosphorous Acid | H₃PO₃ | - |
| | P5 | 1-Hydroxyethane-1,1-Diphosphonic Acid | C₂H₈O₇P₂ | - |
| Fluorine Compound | F1 | Potassium Fluoride | KF | - |
| | F2 | Ammonium Titanium Fluoride | (NH₄)₂TiF₆ | - |
| | F3 | Hydrofluosilicic Acid | H₂SiF₆ | - |
| Silicon Compound | S1 | 3-Aminopropyltrimethoxysilane | H₂NC₃H₆Si(OCH₃)₃ | - |
| | S2 | 3-Glycidoxypropyltriethoxysilane | (H₂CCHO)CH₂OC₃H₆Si(OC₂H₅)₃ | - |
| | S3 | Vinylethoxysilane | H₂C=CHSi(OC₂H₅)₃ | - |

**Table 2-1**

| Category | Chemical Treatment Solution No. | Molybdate | | Vanadium Salt | | Amine | |
|---|---|---|---|---|---|---|---|
| | | Compound | Mo Conc. (g/L) | Compound | V Conc. (g/L) | Compound | Conc. (g/L) |
| Ex. | 1 | M1 | 0.075 | V1 | 0.10 | EA | 0.036 |
| Comp.Ex. | 2 | M1 | 0.019 | V1 | 0.10 | IPA | 0.044 |
| Ex. | 3 | M1 | 0.075 | V2 | 0.01 | EN | 0.035 |
| Ex. | 4 | M1 | 0.075 | V2 | 0.10 | NH | 0.021 |
| Comp.Ex. | 5 | M1 | 5.00 | V3 | 0.10 | EA | 0.036 |
| Ex. | 6 | M1 | 1.51 | V3 | 2.00 | IPA | 0.883 |
| Ex. | 7 | M1 | 0.075 | V1 | 0.10 | EN | 0.036 |
| Comp.Ex. | 8 | M1 | 0.075 | V2 | 0.10 | NH | 0.007 |
| Ex. | 9 | M1 | 24.0 | V3 | 8.00 | EN | 15.1 |
| Comp.Ex. | 10 | M1 | 1.51 | V1 | 8.00 | NH | 8.79 |
| Comp.Ex. | 11 | M1 | 0.015 | V3 | 8.00 | EA | 15.3 |
| Ex. | 12 | M1 | 0.075 | V3 | 0.02 | NH | 0.027 |
| Ex. | 13 | M1 | 24.0 | V2 | 8.00 | EA | 15.3 |
| Ex. | 14 | M1 | 45.2 | V3 | 8.00 | IPA | 18.8 |
| Comp.Ex. | 15 | M1 | 90.4 | V1 | 8.00 | EN | 15.1 |
| Ex. | 16 | M1 | 24.0 | V2 | 10.00 | EA | 19.2 |
| Ex. | 17 | M1 | 24.0 | V2 | 8.00 | IPA | 18.8 |
| Comp.Ex. | 18 | M1 | 24.0 | V3 | 8.00 | EN | 1.89 |
| Ex. | 19 | M1 | 22.6 | V3 | 8.00 | DEA | 39.6 |
| Ex. | 20 | M1 | 0.753 | V3 | 0.80 | EA | 3.07 |

**Table 2-2**

| Category | Chemical Treatment Solution No. | Group 4A Metal Oxoate | | Phosphate | | Mo/V (Molar Ratio) | Amine/V (Molar Ratio) | Color of Treatment Solution |
|---|---|---|---|---|---|---|---|---|
| | | Compound | Zr Conc. (g/L) | Compound | P Conc. (g/L) | | | |
| Ex. | 1 | A1 | 5.0 | P1 | 0.25 | 0.40 | 0.30 | Yellow |
| Comp.Ex. | 2 | A1 | 5.0 | P2 | 0.25 | 0.10 | 0.30 | Yellowish Green |
| Ex. | 3 | A1 | 5.0 | P4 | 0.25 | 4.00 | 3.00 | Yellow |
| Ex. | 4 | A1 | 5.0 | P5 | 0.05 | 0.40 | 0.30 | Yellow |
| Comp.Ex. | 5 | A1 | 5.0 | P3 | 0.25 | 26.55 | 0.30 | Yellowish Green |
| Ex. | 6 | A1 | 5.0 | P3 | 0.25 | 0.40 | 0.30 | Yellow |
| Ex. | 7 | A1 | 5.0 | P4 | 6.00 | 0.40 | 0.30 | Yellow |
| Comp.Ex. | 8 | A1 | 5.0 | P2 | 0.25 | 0.40 | 0.10 | Yellowish Green |
| Ex. | 9 | A1 | 40.0 | P1 | 20.0 | 1.59 | 1.60 | Yellow |
| Comp.Ex. | 10 | A1 | 40.0 | P3 | 20.0 | 0.10 | 1.60 | Yellowish Green |
| Comp.Ex. | 11 | A1 | 40.0 | P2 | 20.0 | 0.00 | 1.60 | Yellowish Green |
| Ex. | 12 | A1 | 40.0 | P5 | 20.0 | 1.59 | 1.60 | Yellow |
| Ex. | 13 | A1 | 40.0 | P4 | 2.00 | 1.59 | 1.60 | Yellow |
| Ex. | 14 | A1 | 40.0 | P3 | 20.0 | 3.00 | 1.60 | Yellow |
| Comp.Ex. | 15 | A1 | 40.0 | P2 | 20.0 | 6.00 | 1.60 | Yellowish Green |
| Ex. | 16 | A1 | 40.0 | P1 | 20.0 | 1.27 | 1.60 | Yellow |
| Ex. | 17 | A1 | 40.0 | P5 | 60.0 | 1.59 | 1.60 | Yellow |
| Comp.Ex. | 18 | A1 | 40.0 | P3 | 20.0 | 1.59 | 0.20 | Yellowish Green |
| Ex. | 19 | A1 | 40.0 | P1 | 20.0 | 1.50 | 2.40 | Yellow |
| Ex. | 20 | A1 | 40.0 | P4 | 20.0 | 0.50 | 3.20 | Yellow |

**Table 3-1**

| Category | Chemical Treatment Solution No. | Molybdate | | Vanadium Salt | | Amine | |
|---|---|---|---|---|---|---|---|
| | | Compound | Mo Conc. (g/L) | Compound | V Conc. (g/L) | Compound | Conc. (g/L) |
| Ex. | 21 | M1 | 24.0 | V2 | 8.00 | NH | 8.79 |
| Ex. | 22 | M1 | 24.0 | V2 | 8.00 | EN | 15.1 |
| Ex. | 23 | M1 | 24.0 | V3 | 8.00 | TMAH | 22.9 |
| Ex. | 24 | M1 | 14.1 | V2 | 5.00 | NH | 11.0 |
| Ex. | 25 | M1 | 1.98 | V3 | 0.30 | EA | 1.15 |
| Ex. | 26 | M1 | 0.075 | V1 | 0.10 | EN | 0.036 |
| Ex. | 27 | M1 | 24.0 | V3 | 8.00 | EDTA | 73.4 |
| Ex. | 28 | M1 | 25.4 | V2 | 3.00 | NH | 1.65 |
| Ex. | 29 | M1 | 0.942 | V2 | 1.00 | NH | 1.10 |
| Ex. | 30 | M1 | 6.59 | V1 | 1.00 | IPA | 5.89 |
| Ex. | 31 | M1 | 3.50 | V2 | 2.00 | NH | 2.20 |
| Ex. | 32 | M1 | 0.075 | V1 | 0.10 | EDTA | 0.172 |
| Ex. | 33 | M1 | 1.41 | V3 | 0.50 | IPA | 1.77 |
| Ex. | 34 | M1 | 0.075 | V2 | 0.10 | NH | 0.021 |
| Ex. | 35 | M1 | 3.77 | V3 | 0.80 | IPA | 3.77 |
| Ex. | 36 | M1 | 24.0 | V2 | 8.00 | NH | 8.79 |
| Ex. | 37 | M1 | 3.50 | V1 | 2.00 | IPA | 4.71 |
| Ex. | 38 | M1 | 0.075 | V3 | 0.10 | EA | 0.036 |
| Ex. | 39 | M1 | 3.11 | V3 | 0.30 | IPA | 1.06 |
| Ex. | 40 | M1 | 7.53 | V2 | 8.00 | EN | 22.6 |

**Table 3-2**

| Category | Chemical Treatment Solution No. | Group 4A Metal Oxoate | | Phosphate | | Mo/V (Molar Ratio) | Amine/V (Molar Ratio) | Color of Treatment Solution |
|---|---|---|---|---|---|---|---|---|
| | | Compound | Zr Conc. (g/L) | Compound | P Conc. (g/L) | | | |
| Ex. | 21 | A1 | 40.0 | P2 | 0.50 | 1.59 | 1.60 | Yellow |
| Ex. | 22 | A1 | 5.0 | P4 | 0.25 | 1.59 | 1.60 | Yellow |
| Ex. | 23 | A1 | 40.0 | P1 | 20.0 | 1.59 | 1.60 | Yellow |
| Ex. | 24 | A1 | 33.5 | P5 | 0.60 | 1.50 | 3.20 | Yellow |
| Ex. | 25 | A1 | 5.0 | P3 | 0.25 | 3.50 | 3.20 | Yellow |
| Ex. | 26 | A1 | 14.0 | P4 | 6.00 | 0.40 | 0.30 | Yellow |
| Ex. | 27 | A1 | 40.0 | P1 | 20.0 | 1.59 | 1.60 | Yellow |
| Ex. | 28 | A1 | 27.0 | P2 | 0.50 | 4.50 | 0.80 | Yellow |
| Ex. | 29 | A1 | 46.5 | P2 | 0.50 | 0.50 | 1.60 | Yellow |
| Ex. | 30 | A1 | 5.0 | P2 | 0.25 | 3.50 | 4.00 | Yellow |
| Ex. | 31 | A1 | 7.5 | P2 | 0.50 | 0.93 | 1.60 | Yellow |
| Ex. | 32 | A1 | 5.0 | P1 | 0.25 | 0.40 | 0.30 | Yellow |
| Ex. | 33 | A1 | 40.0 | P3 | 0.50 | 1.50 | 2.40 | Yellow |
| Ex. | 34 | A1 | 40.0 | P2 | 0.50 | 0.40 | 0.30 | Yellow |
| Ex. | 35 | A1 | 5.0 | P3 | 0.25 | 2.50 | 3.20 | Yellow |
| Ex. | 36 | A1 | 33.5 | P2 | 0.50 | 1.59 | 16.0 | Yellow |
| Ex. | 37 | A1 | 14.0 | P2 | 0.50 | 0.93 | 1.60 | Yellow |
| Ex. | 38 | A1 | 33.5 | P3 | 0.50 | 0.40 | 0.30 | Yellow |
| Ex. | 39 | A1 | 40.0 | P4 | 20.0 | 5.50 | 2.40 | Yellow |
| Ex. | 40 | A1 | 20.5 | P4 | 0.50 | 0.50 | 2.40 | Yellow |

**Table 4-1**

| Category | Chemical Treatment Solution No. | | | Vanadium Salt | | Amine | |
|---|---|---|---|---|---|---|---|
| | | Compound | Mo Conc. (g/L) | Compound | V Conc. (g/L) | Compound | Conc. (g/L) |
| Ex. | 41 | M1 | 24.0 | V3 | 8.00 | EN | 15.1 |
| Ex. | 42 | M1 | 0.075 | V3 | 0.10 | NH | 0.021 |
| Ex. | 43 | M1 | 0.471 | V1 | 0.50 | DEA | 4.12 |
| Ex. | 44 | M1 | 24.0 | V2 | 8.00 | NH | 8.79 |
| Ex. | 45 | M1 | 23.5 | V2 | 5.00 | IPA | 29.4 |
| Ex. | 46 | M1 | 24.0 | V2 | 8.00 | NH | 8.79 |
| Ex. | 47 | M1 | 0.075 | V3 | 0.10 | IPA | 0.044 |
| Ex. | 48 | M1 | 0.075 | V2 | 0.10 | IPA | 0.044 |
| Ex. | 49 | M1 | 0.075 | V1 | 0.10 | TMAH | 0.054 |
| Ex. | 50 | M1 | 14.1 | V1 | 3.00 | EN | 5.75 |

**Table 4-2**

| Category | Chemical Treatment Solution No. | Group 4A Metal Oxoate | | Phosphate | | Mo/V (Molar Ratio) | Amine/V (Molar Ratio) | Color of Treatment Solution |
|---|---|---|---|---|---|---|---|---|
| | | Compound | Zr Conc. (g/L) | Compound | P Conc. (g/L) | | | |
| Ex. | 41 | A1 | 40.0 | P5 | 20.0 | 1.59 | 1.60 | Yellow |
| Ex. | 42 | A1 | 40.0 | P2 | 20.0 | 0.40 | 0.30 | Yellow |
| Ex. | 43 | A1 | 5.0 | P1 | 0.25 | 0.50 | 4.00 | Yellow |
| Ex. | 44 | A1 | 46.5 | P2 | 0.50 | 1.59 | 1.60 | Yellow |
| Ex. | 45 | A1 | 27.0 | P1 | 7.50 | 2.50 | 4.00 | Yellow |
| Ex. | 46 | A1 | 5.0 | P5 | 0.25 | 1.59 | 1.60 | Yellow |
| Ex. | 47 | A1 | 40.0 | P3 | 20.0 | 0.40 | 0.30 | Yellow |
| Ex. | 48 | A1 | 27.0 | P5 | 7.50 | 0.40 | 0.30 | Yellow |
| Ex. | 49 | A1 | 5.0 | P1 | 0.25 | 0.40 | 0.30 | Yellow |
| Ex. | 50 | A1 | 7.5 | P4 | 6.00 | 2.50 | 1.60 | Yellow |

The surface of the original sheet for chemical treatment was degreased, and dried. Then, each of chemical treatment solutions Nos. 1 to 18 shown in Table 2-1 was applied to the surface of the original sheet for chemical treatment, and immediately thereafter heated and dried at a low temperature (a temperature of the steel strip of 40 or 80°C) using an automatic discharge type electric hot air oven to form a chemical conversion film. Thus, chemically treated steel sheets Nos. 1 to 36 having the chemical conversion film were produced. Note that the deposition amount of the chemical conversion film in all the chemically treated steel sheets was set at 200 mg/m².

### [Evaluation of Chemically Treated Steel Sheet]

For a test specimen cut out from each chemically treated steel sheet, the structure of the chemical conversion film was identified; the percentage of pentavalent vanadium based on mixed-valent vanadium in the film was determined; the film deposition amount was measured; and the test specimen was subjected to corrosion resistance test and blackening resistance test.

### (1) Identification of Structure of Chemical Conversion Film

The structure of the chemical conversion film was identified using the above-mentioned TEM, EDS, and XPS.

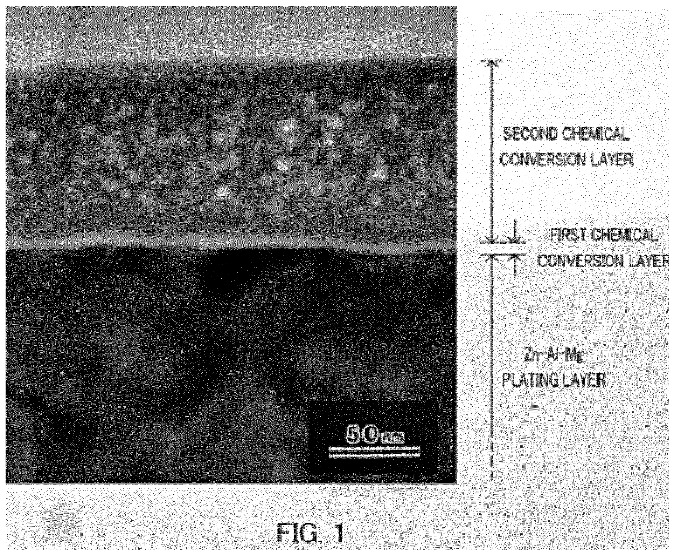

For example, FIG. 1 is a TEM image of the cross-section of a test specimen of chemically treated steel sheet No. 17. As illustrated in FIG. 1, the chemical conversion film of chemically treated steel sheet has a two-layer structure including the first chemical conversion layer and the second chemical conversion layer.

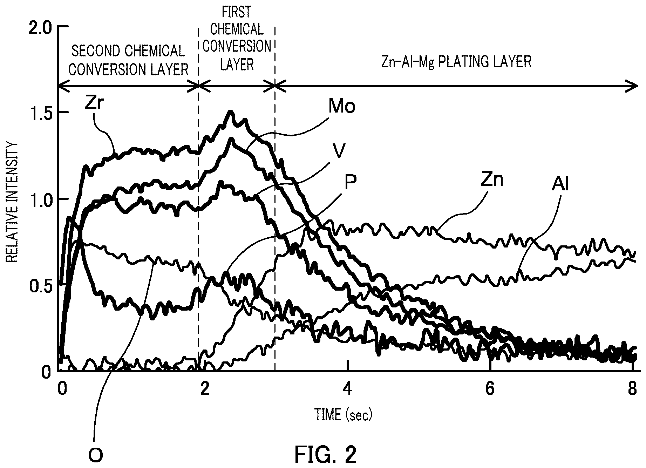

FIG. 2 shows an element distribution of the test specimen of chemically treated steel sheet No. 17, from the surface thereof toward the depth direction, measured using GDS. The abscissa in FIG. 2 indicates a measuring time (corresponding to the depth from the surface), and the ordinate indicates the relative intensity. As shown in FIG. 2, in the chemical conversion film of chemically treated steel sheet No. 17, the first chemical conversion layer contains large amounts of molybdenum, vanadium, and phosphorus, and the second conversion layer contains zirconium.

Although not specifically illustrated, it was also confirmed, in other chemically treated steel sheet categorized in Examples, that the chemical conversion film has the two-layer structure in the same manner as chemically treated steel sheet No. 17, and contains vanadium, molybdenum, and phosphorus in the first chemical conversion layer and a group 4 metal oxoate in the second chemical conversion layer. The two-layer structure in the chemical conversion film was not confirmed in chemically treated steel sheets categorized in Comparative Examples.

### (2) Measurement of Deposition Amount of Chemical Conversion Film

For the confirmation of the deposition amount, zirconium in the film was measured using a fluorescent X-ray apparatus, and the measurement was used as an index the deposition amount.

### (3) Measurement of Percentage of Pentavalent Vanadium based on Mixed-valent Vanadium in Chemical Conversion Film

The percentage of pentavalent vanadium based on mixed-valent vanadium (V⁵⁺/V) in the chemical conversion film was determined by analyzing the chemical binding state of vanadium in the chemical conversion film using X-ray Photoelectron Spectroscopy (XPS). Two points of the surface layer of the chemical conversion film and the interface between the chemical conversion film and the plating layer were taken as points for analysis for each site of 10 locations randomly selected from the above-mentioned test specimen. The analysis of the interface between the chemical conversion film and the plating layer was performed after the chemical conversion film was sputtered using an argon beam from the surface layer. The depth at which the chemical conversion film was sputtered was determined by measuring the thickness of the chemical conversion film from the results of observation of the film cross-section using TEM. The percentage of pentavalent vanadium based on mixed-valent vanadium was determined from the percentage of a peak area of about 516.5 eV derived from V⁵⁺ (S_{V5}) based on the total sum of the peak area derived from V⁵⁺ and a peak area of 514 eV derived from V⁴⁺ (S_{V4}) (S_{V5}/(S_{V4} + S_{V5}). The average value of the percentages at 10 measuring locations in each test specimen was employed as the percentage of pentavalent vanadium based on mixed-valent vanadium (V⁵⁺/V) in the chemically treated steel sheet.

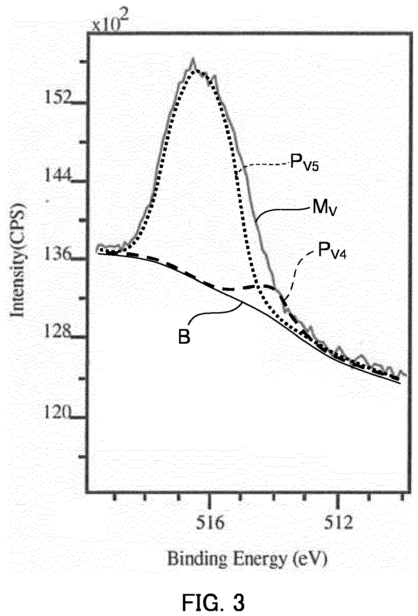

For example, FIG. 3 is an intensity profile of chemical binding energy corresponding to 2p orbit of vanadium in a film/plating layer interface in one location of 10 measuring locations at which a test specimen of chemically treated steel sheet No. 12 produced by drying chemical treatment solution No. 4 at a drying temperature of 80°C was measured. The abscissa in FIG. 3 indicates binding energy, and the ordinate indicates relative intensity for a short period of time (per second). Further, solid line Mv in FIG. 3 is an intensity profile of chemical binding energy actually measured in the measuring point. Dotted line Pᵥ₅ indicates a peak derived from pentavalent vanadium, dotted line Pᵥ₄ indicates a peak derived from tetravalent vanadium, and solid line B indicates a baseline.

It could be confirmed, from FIG. 3, that the percentage of V⁵⁺ in the chemical conversion film was 0.7 or more in the above-mentioned test specimen. It was confirmed that the percentage of V⁵⁺ in the chemical conversion film was 0.7 or more also in other chemically treated steel sheets, although not particularly illustrated.

### (4) Flat Part Corrosion Resistance Test

The edge surface of the test specimen of each chemically treated steel sheet was sealed and subjected to a salt spray test for 120 hours in accordance with JIS Z2371, and thereafter white rust generated on a surface of the test specimen was observed. Each chemically treated steel sheet was evaluated as follows: when the percentage of an area where white rust was generated was 5% or less, the evaluation was "A"; when the percentage was more than 5% to 10% or less, the evaluation was "B"; when the percentage was more than 10% to less than 30%, the evaluation was "C"; and when the percentage was 30% or more, the evaluation was "D."

### (5) Worked Part Corrosion Resistance Test

A bead drawing test (bead height: 4 mm, pressure: 1.0 kN) was performed for a test specimen of 30 mm × 250 mm of each chemically treated steel sheet, and the edge surface of the test specimen was sealed and subjected to a salt spray test for 24 hours in accordance with JIS Z2371; thereafter white rust generated on a sliding surface was observed. Each chemically treated steel sheet was evaluated as follows: when the percentage of an area where white rust was generated was 5% or less, the evaluation was "A"; when the percentage was more than 5% to 10% or less, the evaluation was "B"; when the percentage was more than 10% to less than 30%, the evaluation was "C"; and when the percentage was 30% or more, the evaluation was "D."

### (6) Blackening Resistance Test

A test specimen of each chemically treated steel sheet was left to stand for a predetermined time in a humid atmosphere (temperature 60°C, humidity 90%RH), and thereafter the brightnesses of the test specimen before and after the test were compared. The brightness (L value) of the test specimen was measured using a spectroscopic color-difference meter (TC-1800; Tokyo Denshoku Co., Ltd.). Each chemically treated steel sheet was evaluated as follows: when brightness difference ΔL was 3.0 or less, the evaluation was "A"; when the brightness difference ΔL was more than 3.0 to 6.0 or less, the evaluation was "B"; when the brightness difference ΔL was more than 6.0 to less than 10.0, the evaluation was "C"; and when the brightness difference ΔL was 10.0 or more, the evaluation was "D."

### (7) Evaluation Results

The chemical treatment solutions used, the ratio of each element in the chemical conversion film, the results of the corrosion resistance test, and the results of the blackening resistance test for each chemically treated steel sheet are shown in Tables 5-1, 5-2, 6-1, and 6-2. Note that, in the following tables, the ratio of each element in the chemical conversion film is represented as parts by mass of each element based on 100 parts by mass of zirconium.

**Table 5-1**

| Category | Chemically treated Steel Sheet No. | Chemical Treatment Solution No. | Film Deposition Amount (mg/m²) | Drying Temperature (°C) | Ratio of Each Element in Chemical Conversion Film (Parts by Mass) | | |
|---|---|---|---|---|---|---|---|
| | | | | | Mo | V | P |
| Ex. | 1 | 1 | 200 | 40 | 1.5 | 2.0 | 5.0 |
| Comp. Ex. | 2 | 2 | 200 | 40 | 0.4 | 2.0 | 5.0 |
| Ex. | 3 | 3 | 200 | 40 | 1.5 | 0.2 | 5.0 |
| Ex. | 4 | 4 | 200 | 40 | 1.5 | 2.0 | 1.0 |
| Comp. Ex. | 5 | 5 | 200 | 40 | 100.0 | 2.0 | 5.0 |
| Ex. | 6 | 6 | 200 | 40 | 30.1 | 40.0 | 5.0 |
| Ex. | 7 | 7 | 200 | 40 | 1.5 | 2.0 | 120.0 |
| Comp. Ex. | 8 | 8 | 200 | 40 | 1.5 | 2.0 | 5.0 |
| Ex. | 9 | 1 | 200 | 80 | 1.5 | 2.0 | 5.0 |
| Comp. Ex. | 10 | 2 | 200 | 80 | 0.4 | 2.0 | 5.0 |
| Ex. | 11 | 3 | 200 | 80 | 1.5 | 0.2 | 5.0 |
| Ex. | 12 | 4 | 200 | 80 | 1.5 | 2.0 | 1.0 |
| Comp. Ex. | 13 | 5 | 200 | 80 | 100.0 | 2.0 | 5.0 |
| Ex. | 14 | 6 | 200 | 80 | 30.1 | 40.0 | 5.0 |
| Ex. | 15 | 7 | 200 | 80 | 1.5 | 2.0 | 120.0 |
| Comp. Ex. | 16 | 8 | 200 | 80 | 1.5 | 2.0 | 5.0 |

**Table 5-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 1 | 1 | 0.92 | A | A | A |
| Comp. Ex. | 2 | 2 | 0.40 | D | D | D |
| Ex. | 3 | 3 | 0.88 | B | B | B |
| Ex. | 4 | 4 | 0.79 | B | B | A |
| Comp. Ex. | 5 | 5 | 0.45 | C | D | D |
| Ex. | 6 | 6 | 0.95 | A | B | A |
| Ex. | 7 | 7 | 0.75 | B | B | A |
| Comp. Ex. | 8 | 8 | 0.40 | C | C | D |
| Ex. | 9 | 1 | 0.95 | A | A | A |
| Comp. Ex. | 10 | 2 | 0.41 | D | D | D |
| Ex. | 11 | 3 | 0.91 | B | B | B |
| Ex. | 12 | 4 | 0.81 | B | B | A |
| Comp. Ex. | 13 | 5 | 0.46 | C | D | D |
| Ex. | 14 | 6 | 0.98 | A | B | A |
| Ex. | 15 | 7 | 0.77 | B | B | A |
| Comp. Ex. | 16 | 8 | 0.41 | C | C | D |

**Table 6-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 17 | 9 | 200 | 40 | 60.0 | 20.0 | 50.0 |
| Comp. Ex. | 18 | 10 | 200 | 40 | 3.8 | 20.0 | 50.0 |
| Comp. Ex. | 19 | 11 | 200 | 40 | 0.0 | 20.0 | 50.0 |
| Ex. | 20 | 12 | 200 | 40 | 0.2 | 0.1 | 50.0 |
| Ex. | 21 | 13 | 200 | 40 | 60.0 | 20.0 | 5.0 |
| Ex. | 22 | 14 | 200 | 40 | 113.0 | 20.0 | 50.0 |
| Comp. Ex. | 23 | 15 | 200 | 40 | 226.0 | 20.0 | 50.0 |
| Ex. | 24 | 16 | 200 | 40 | 60.0 | 25.0 | 50.0 |
| Ex. | 25 | 17 | 200 | 40 | 60.0 | 20.0 | 150.0 |
| Comp. Ex. | 26 | 18 | 200 | 40 | 60.0 | 20.0 | 50.0 |
| Ex. | 27 | 9 | 200 | 80 | 60.0 | 20.0 | 50.0 |
| Comp. Ex. | 28 | 10 | 200 | 80 | 3.8 | 20.0 | 50.0 |
| Comp. Ex. | 29 | 11 | 200 | 80 | 0.0 | 20.0 | 50.0 |
| Ex. | 30 | 12 | 200 | 80 | 0.2 | 0.1 | 50.0 |
| Ex. | 31 | 13 | 200 | 80 | 60.0 | 20.0 | 5.0 |
| Ex. | 32 | 14 | 200 | 80 | 113.0 | 20.0 | 50.0 |
| Comp. Ex. | 33 | 15 | 200 | 80 | 226.0 | 20.0 | 50.0 |
| Ex. | 34 | 16 | 200 | 80 | 60.0 | 25.0 | 50.0 |
| Ex. | 35 | 17 | 200 | 80 | 60.0 | 20.0 | 150.0 |
| Comp. Ex. | 36 | 18 | 200 | 80 | 60.0 | 20.0 | 50.0 |

**Table 6-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 17 | 9 | 0.92 | A | A | A |
| Comp. Ex. | 18 | 10 | 0.43 | C | C | D |
| Comp. Ex. | 19 | 11 | 0.35 | C | C | D |
| Ex. | 20 | 12 | 0.95 | B | B | B |
| Ex. | 21 | 13 | 0.92 | B | B | A |
| Ex. | 22 | 14 | 0.86 | A | B | A |
| Comp. Ex. | 23 | 15 | 0.25 | C | D | D |
| Ex. | 24 | 16 | 0.85 | A | B | A |
| Ex. | 25 | 17 | 0.90 | B | B | A |
| Comp. Ex. | 26 | 18 | 0.32 | C | C | D |
| Ex. | 27 | 9 | 0.95 | A | A | A |
| Comp. Ex. | 28 | 10 | 0.44 | C | C | D |
| Comp. Ex. | 29 | 11 | 0.36 | C | C | D |
| Ex. | 30 | 12 | 0.98 | B | B | B |
| Ex. | 31 | 13 | 0.95 | B | B | A |
| Ex. | 32 | 14 | 0.89 | B | D | B |
| Comp. Ex. | 33 | 15 | 0.26 | C | D | D |
| Ex. | 34 | 16 | 0.88 | A | B | A |
| Ex. | 35 | 17 | 0.93 | B | B | A |
| Comp. Ex. | 36 | 18 | 0.33 | C | C | D |

As is obvious from Tables 5-1, 5-2, 6-1, and 6-2, chemically treated steel sheets each having a chemical conversion film in which the percentage of pentavalent vanadium based on mixed-valent vanadium in the chemical conversion film is 0.7 or more, and which includes a first chemical conversion layer containing vanadium, molybdenum and phosphorus, and a second chemical conversion layer disposed on the first chemical conversion layer and containing a group 4A metal oxoate, the chemical conversion film being disposed on the surface of a zinc-based plated steel sheet having a zinc-based plating layer containing 0.1 to 22.0 mass % of aluminum have favorable corrosion resistance and blackening resistance. The chemical conversion film is obtained by applying a chemical treatment solution which contains a water-soluble molybdate, a vanadium salt, an amine, a group 4A metal oxoate, and a phosphate, in which the molar ratio of molybdenum to vanadium is 0.4 to 5.5, and the molar ratio of an amine to vanadium is 0.3 or more to the zinc-based plated steel sheet, followed by drying. The favorable corrosion resistance and blackening resistance of the chemically treated steel sheets are obtained even when the chemical treatment solution applied to the plated steel sheet is dried at a relatively low drying temperature of 40°C or 80°C.

In addition, as is obvious from Tables 5-1, 5-2, 6-1, and 6-2, when the percentage of pentavalent vanadium in the chemical conversion film is 0.7 or less, corrosion resistance and blackening resistance are inferior.

### [Example 2]

Next, chemically treated steel sheets Nos. 37 to 100 were produced in the same manner as chemical treated steel sheet No. 1 except that the type and the deposition amount of the chemical treatment solutions were changed as shown in the following tables, and were evaluated in the same manner as chemically treated steel sheets Nos. 1 to 36. The results are shown in the following Tables 7-1, 7-2, 8-1, 8-2, 9-1, 9-2, 10-1, and 10-2.

**Table 7-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 37 | 19 | 200 | 40 | 56.5 | 20.0 | 50.0 |
| Ex. | 38 | 20 | 500 | 40 | 1.9 | 2.0 | 50.0 |
| Ex. | 39 | 21 | 500 | 40 | 60.0 | 20.0 | 1.3 |
| Ex. | 40 | 22 | 100 | 40 | 480.0 | 160.0 | 5.0 |
| Ex. | 41 | 23 | 300 | 40 | 60.0 | 20.0 | 50.0 |
| Ex. | 42 | 24 | 1000 | 40 | 42.2 | 14.9 | 1.8 |
| Ex. | 43 | 25 | 500 | 40 | 39.6 | 6.0 | 5.0 |
| Ex. | 44 | 26 | 400 | 40 | 0.5 | 0.7 | 42.9 |
| Ex. | 45 | 27 | 250 | 40 | 60.0 | 20.0 | 50.0 |
| Ex. | 46 | 28 | 100 | 40 | 94.2 | 11.1 | 1.9 |
| Ex. | 47 | 29 | 150 | 40 | 2.0 | 2.2 | 1.1 |
| Ex. | 48 | 30 | 50 | 40 | 131.8 | 20.0 | 5.0 |
| Ex. | 49 | 31 | 100 | 40 | 46.7 | 26.7 | 6.7 |
| Ex. | 50 | 32 | 400 | 40 | 1.5 | 2.0 | 5.0 |
| Ex. | 51 | 33 | 250 | 40 | 3.5 | 1.3 | 1.3 |
| Ex. | 52 | 34 | 10000 | 40 | 0.2 | 0.3 | 1.3 |

**Table 7-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 37 | 19 | 0.87 | B | B | A |
| Ex. | 38 | 20 | 0.93 | A | A | A |
| Ex. | 39 | 21 | 0.96 | B | B | A |
| Ex. | 40 | 22 | 0.92 | B | B | A |
| Ex. | 41 | 23 | 0.91 | B | B | A |
| Ex. | 42 | 24 | 0.89 | A | B | A |
| Ex. | 43 | 25 | 0.85 | B | A | A |
| Ex. | 44 | 26 | 0.93 | B | B | B |
| Ex. | 45 | 27 | 0.76 | B | B | A |
| Ex. | 46 | 28 | 0.79 | B | B | A |
| Ex. | 47 | 29 | 0.91 | B | A | A |
| Ex. | 48 | 30 | 0.86 | A | B | A |
| Ex. | 49 | 31 | 0.98 | B | A | A |
| Ex. | 50 | 32 | 0.86 | B | B | A |
| Ex. | 51 | 33 | 0.70 | A | B | A |
| Ex. | 52 | 34 | 0.95 | B | A | B |

**Table 8-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 53 | 35 | 1000 | 40 | 75.3 | 16.0 | 5.0 |
| Ex. | 54 | 36 | 300 | 40 | 71.6 | 23.9 | 1.5 |
| Ex. | 55 | 37 | 300 | 40 | 25.0 | 14.3 | 3.6 |
| Ex. | 56 | 38 | 150 | 40 | 0.2 | 0.3 | 1.5 |
| Ex. | 57 | 39 | 1000 | 40 | 7.8 | 0.8 | 50.0 |
| Ex. | 58 | 40 | 500 | 40 | 36.7 | 39.0 | 2.4 |
| Ex. | 59 | 41 | 100 | 40 | 60.0 | 20.0 | 50.0 |
| Ex. | 60 | 42 | 300 | 40 | 0.2 | 0.3 | 50.0 |
| Ex. | 61 | 43 | 150 | 40 | 9.4 | 10.0 | 5.0 |
| Ex. | 62 | 44 | 50 | 40 | 51.6 | 17.2 | 1.1 |
| Ex. | 63 | 45 | 200 | 40 | 87.2 | 18.5 | 27.8 |
| Ex. | 64 | 46 | 300 | 40 | 480.0 | 160.0 | 5.0 |
| Ex. | 65 | 47 | 50 | 40 | 0.2 | 0.3 | 50.0 |
| Ex. | 66 | 48 | 200 | 40 | 0.3 | 0.4 | 27.8 |
| Ex. | 67 | 49 | 250 | 40 | 1.5 | 2.0 | 5.0 |
| Ex. | 68 | 50 | 50 | 40 | 188.3 | 40.0 | 80.0 |

**Table 8-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 53 | 35 | 0.83 | A | B | A |
| Ex. | 54 | 36 | 0.79 | A | B | A |
| Ex. | 55 | 37 | 0.75 | B | A | A |
| Ex. | 56 | 38 | 0.78 | A | A | B |
| Ex. | 57 | 39 | 0.71 | B | A | B |
| Ex. | 58 | 40 | 0.93 | A | B | A |
| Ex. | 59 | 41 | 0.85 | A | A | A |
| Ex. | 60 | 42 | 0.98 | B | A | B |
| Ex. | 61 | 43 | 0.85 | B | B | A |
| Ex. | 62 | 44 | 0.79 | A | B | A |
| Ex. | 63 | 45 | 0.99 | A | A | A |
| Ex. | 64 | 46 | 0.97 | B | B | A |
| Ex. | 65 | 47 | 0.90 | B | A | B |
| Ex. | 66 | 48 | 0.73 | B | A | B |
| Ex. | 67 | 49 | 0.86 | B | B | A |
| Ex. | 68 | 50 | 0.71 | B | B | A |

**Table 9-1**

| Category | Chemically Treated Steel Sheet N0. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 69 | 19 | 200 | 80 | 56.5 | 20.0 | 50.0 |
| Ex. | 70 | 20 | 500 | 80 | 1.9 | 2.0 | 50.0 |
| Ex. | 71 | 21 | 500 | 80 | 60.0 | 20.0 | 1.3 |
| Ex. | 72 | 22 | 100 | 80 | 480.0 | 160.0 | 5.0 |
| Ex. | 73 | 23 | 300 | 80 | 60.0 | 20.0 | 50.0 |
| Ex. | 74 | 24 | 1000 | 80 | 42.2 | 14.9 | 1.8 |
| Ex. | 75 | 25 | 500 | 80 | 39.6 | 6.0 | 5.0 |
| Ex. | 76 | 26 | 400 | 80 | 0.5 | 0.7 | 42.9 |
| Ex. | 77 | 27 | 250 | 80 | 60.0 | 20.0 | 50.0 |
| Ex. | 78 | 28 | 100 | 80 | 94.2 | 11.1 | 1.9 |
| Ex. | 79 | 29 | 150 | 80 | 2.0 | 2.2 | 1.1 |
| Ex. | 80 | 30 | 50 | 80 | 13108 | 20.0 | 5.0 |
| Ex. | 81 | 31 | 100 | 80 | 46.7 | 26.7 | 6.7 |
| Ex. | 82 | 32 | 400 | 80 | 1.5 | 2.0 | 5.0 |
| Ex. | 83 | 33 | 250 | 80 | 3.5 | 1.3 | 1.3 |
| Ex. | 84 | 34 | 10000 | 80 | 0.2 | 0.3 | 1.3 |

**Table 9-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 69 | 19 | 0.87 | B | B | A |
| Ex. | 70 | 20 | 0.93 | A | A | A |
| Ex. | 71 | 21 | 0.73 | B | B | A |
| Ex. | 72 | 22 | 0.86 | B | B | A |
| Ex. | 73 | 23 | 0.73 | B | B | A |
| Ex. | 74 | 24 | 0.73 | A | B | A |
| Ex. | 75 | 25 | 0.89 | B | A | A |
| Ex. | 76 | 26 | 0.72 | B | B | B |
| Ex. | 77 | 27 | 0.75 | B | B | A |
| Ex. | 78 | 28 | 0.81 | B | B | A |
| Ex. | 79 | 29 | 0.75 | B | A | A |
| Ex. | 80 | 30 | 0.84 | A | B | A |
| Ex. | 81 | 31 | 0.77 | B | A | A |
| Ex. | 82 | 32 | 0.81 | B | B | A |
| Ex. | 83 | 33 | 0.92 | A | B | A |
| Ex. | 84 | 34 | 0.72 | B | A | B |

**Table 10-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 85 | 35 | 1000 | 80 | 75.3 | 16.0 | 5.0 |
| Ex. | 86 | 36 | 300 | 80 | 71.6 | 23.9 | 1.5 |
| Ex. | 87 | 37 | 300 | 80 | 25.0 | 14.3 | 3.6 |
| Ex. | 88 | 38 | 150 | 80 | 0.2 | 0.3 | 1.5 |
| Ex. | 89 | 39 | 1000 | 80 | 7.8 | 0.8 | 50.0 |
| Ex. | 90 | 40 | 500 | 80 | 36.7 | 39.0 | 2.4 |
| Ex. | 91 | 41 | 100 | 80 | 60.0 | 20.0 | 50.0 |
| Ex. | 92 | 42 | 300 | 80 | 0.2 | 0.3 | 50.0 |
| Ex. | 93 | 43 | 150 | 80 | 9.4 | 10.0 | 5.0 |
| Ex. | 94 | 44 | 50 | 80 | 51.6 | 17.2 | 1.1 |
| Ex. | 95 | 45 | 200 | 80 | 87.2 | 18.5 | 27.8 |
| Ex. | 96 | 46 | 300 | 80 | 480.0 | 160.0 | 5.0 |
| Ex. | 97 | 47 | 50 | 80 | 0.2 | 0.3 | 50.0 |
| Ex. | 98 | 48 | 200 | 80 | 0.3 | 0.4 | 27.8 |
| Ex. | 99 | 49 | 250 | 80 | 1.5 | 2.0 | 5.0 |
| Ex. | 100 | 50 | 50 | 80 | 188.3 | 40.0 | 80.0 |

**Table 10-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 85 | 35 | 0.90 | A | B | A |
| Ex. | 86 | 36 | 0.71 | A | B | A |
| Ex. | 87 | 37 | 0.89 | B | A | A |
| Ex. | 88 | 38 | 0.97 | A | A | B |
| Ex. | 89 | 39 | 0.82 | B | A | B |
| Ex. | 90 | 40 | 0.77 | A | B | A |
| Ex. | 91 | 41 | 0.90 | A | A | A |
| Ex. | 92 | 42 | 0.86 | B | A | B |
| Ex. | 93 | 43 | 0.70 | B | B | A |
| Ex. | 94 | 44 | 0.98 | A | B | A |
| Ex. | 95 | 45 | 0.98 | A | A | A |
| Ex. | 96 | 46 | 0.79 | B | B | A |
| Ex. | 97 | 47 | 0.95 | B | A | B |
| Ex. | 98 | 48 | 0.81 | B | A | B |
| Ex. | 99 | 49 | 0.90 | B | B | A |
| Ex. | 100 | 50 | 0.79 | B | B | A |

As is obvious from Tables 7-1, 7-2, 8-1, 8-2, 9-1, 9-2, 10-1, and 10-2, chemically treated steel sheets each having a chemical conversion film in which the percentage of pentavalent vanadium based on mixed-valent vanadium in the chemical conversion film is 0.7 or more, and which includes a first chemical conversion layer containing vanadium, molybdenum and phosphorus, and a second chemical conversion layer disposed on the first chemical conversion layer and containing a group 4 metal oxoate, the chemical conversion film being disposed on the surface of a zinc-based plated steel sheet having a zinc-based plating layer containing 0.1 to 22.0 mass % of aluminum have favorable corrosion resistance and blackening resistance in a wide range of the deposition amount of the chemical conversion film. The chemical conversion film is obtained by applying a chemical treatment solution which contains a water-soluble molybdate, a vanadium salt, an amine, a group 4A metal oxoate, and a phosphate, in which the molar ratio of molybdenum to vanadium is 0.4 to 5.5, and the molar ratio of an amine to vanadium is 0.3 or more to the zinc-based plated steel sheet, followed by drying. The favorable corrosion resistance and blackening resistance of the chemically treated steel sheets are obtained, regardless of the deposition amount of the chemical conversion film, even when the chemical treatment solution applied to the plated steel sheet is dried at a relatively low drying temperature of 40 or 80°C.

Next, chemically treated steel sheets Nos. 101 to 106 which were comparative materials were prepared in the same manner as chemical treated steel sheet No. 1 except that the chemical treatment solutions were respectively changed to prior arts A to C, and were evaluated in the same manner as Example 1 according to the above-mentioned evaluation criteria. The results are shown in the following Tables 11-1 and 11-2.

### [Prior Art A]

Commercially available partially reduced chromate treatment solution (ZM-3387; Nihon Parkerizing Co., Ltd.) was applied to the surface of an original sheet for chemical treatment, and immediately thereafter heated and dried at a low temperature (a temperature of the steel strip of 40 or 80°C) using an automatic discharge type electric hot air oven to form a chemical conversion film. Note that the chrome deposition amount of the chemical conversion film was 200 mg/m².

### [Prior Art B]

A blue transparent chemical treatment solution to which ammonium zirconium carbonate, vanadyl tartrate, phosphoric acid and citric acid were added was applied to the surface of an original sheet for chemical treatment, and immediately thereafter heated and dried at a low temperature (a temperature of the steel strip of 40 or 80°C) using an automatic discharge type electric hot air oven to form a chemical conversion film. The vanadyl tartrate was prepared by reducing vanadium pentoxide in an aqueous tartaric acid solution. Note that the zirconium deposition amount and the vanadium deposition amount of the chemical conversion film were both 200 mg/m².

### [Prior Art C]

A colorless transparent chemical treatment solution to which titanium hydrofluoric acid and phosphoric acid were added was applied to the surface of an original sheet for chemical treatment, and immediately thereafter heated and dried at a low temperature (a temperature of the steel strip of 40 or 80°C) using an automatic discharge type electric hot air oven to form a chemical conversion film. Note that the titanium deposition amount of the chemical conversion film was 200 mg/m².

**Table 11-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Comp. Ex. | 101 | Prior Art A | 200 | 40 | - | - | - |
| Comp. Ex. | 102 | Prior Art A | 200 | 80 | - | - | - |
| Comp. Ex. | 103 | Prior Art B | 200 | 40 | - | - | - |
| Comp. Ex. | 104 | Prior Art B | 200 | 80 | - | - | - |
| Comp. Ex. | 105 | Prior Art C | 200 | 40 | - | - | - |
| Comp. Ex. | 106 | Prior Art C | 200 | 80 | - | - | - |

**Table 11-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Comp. Ex. | 101 | Prior Art A | - | C | D | A |
| Comp. Ex. | 102 | Prior Art A | - | C | D | A |
| Comp. Ex. | 103 | Prior Art B | - | D | D | D |
| Comp. Ex. | 104 | Prior Art B | - | C | D | D |
| Comp. Ex. | 105 | Prior Art C | - | D | D | D |
| Comp. Ex. | 106 | Prior Art C | - | C | D | D |

The chemically treated steel sheets Nos. 101 and 102 obtained by using the commercially available chromate treatment solution were inferior in flat part corrosion resistance and worked part corrosion resistance, since the chemical treatment solution was dried at a low temperature. Further, the chemically treated steel sheets Nos. 103 to 106 obtained by using the chemical treatment solution in which vanadium was reduced with the addition of an organic acid or the chemical treatment solution containing a fluoride were each markedly inferior in flat part corrosion resistance, worked part corrosion resistance and blackening resistance, since the chemical treatment solutions were dried at a low temperature.

As described above, it can be found, from the comparison between the test results of prior arts shown in Tables 11-1, 11-2 and Examples shown in Tables 5-1, 5-2, 6-1, 6-2, 7-1, 7-2, 8-1, 8-2, 9-1, 9-2, 10-1, 10-2, that the chemically treated steel sheet according to the present invention has favorable corrosion resistance and blackening resistance compared to that of the prior arts. Further, it can be found that the chemically treated steel sheet is obtained by the production of a chemical conversion film made from the chemical treatment solution according to the present invention. Furthermore, it can be found that the favorable corrosion resistance and blackening resistance are also obtained by drying the chemical treatment solution at a low temperature.

### [Example 3]

A chemically treated steel sheet produced according to the following procedure was provided. For an original sheet for chemical treatment, a steel strip of ultra-low carbon titanium-added steel having a sheet thickness of 0.5 mm was used as the substrate steel to produce a hot-dip zinc plated steel sheet of having a zinc-based layer containing 0.018 mass % of aluminum (plating deposition amount of 90 g/m² per side), in a continuous hot-dip zinc plating production line, and the produced plated steel sheet was used as the original sheet for chemical treatment.

The surface of the original sheet for chemical treatment was degreased, and dried. Then, each of chemical treatment solutions Nos. 19 to 50 shown in Tables 2-1, 2-2, 3-1, 3-2, 4-1, and 4-2 was applied to the surface of the original sheet for chemical treatment, and immediately thereafter heated and dried at a low temperature (a temperature of the steel strip of 40 or 80°C) using an automatic discharge type electric hot air oven to form a chemical conversion film. Thus, chemically treated steel sheets Nos. 107 to 170 were produced.

For a test specimen cut out from each chemically treated steel sheet, the structure of the chemical conversion film was identified; the percentage of pentavalent vanadium based on mixed-valent vanadium in the film was determined; the film deposition amount was measured; and the test specimen was subjected to corrosion resistance test and blackening resistance test. The chemical treatment solutions used, the ratio of each element in the chemical conversion film, the results of the corrosion resistance test, and the results of the blackening resistance test for each chemically treated steel sheet are shown in Tables 12-1, 12-2, 13-1, 13-2, 14-1, 14-2, 15-1, and 15-2. Note that the ratio of each element in the chemical conversion film is represented as parts by mass of each element based on 100 parts by mass of zirconium.

**Table 12-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 107 | 19 | 200 | 40 | 56.5 | 20.0 | 50.0 |
| Ex. | 108 | 20 | 500 | 40 | 1.9 | 2.0 | 50.0 |
| Ex. | 109 | 21 | 500 | 40 | 60.0 | 20.0 | 1.3 |
| Ex. | 110 | 22 | 100 | 40 | 480.0 | 160.0 | 5.0 |
| Ex. | 111 | 23 | 300 | 40 | 60.0 | 20.0 | 50.0 |
| Ex. | 112 | 24 | 1000 | 40 | 42.2 | 14.9 | 1.8 |
| Ex. | 113 | 25 | 500 | 40 | 39.6 | 6.0 | 5.0 |
| Ex. | 114 | 26 | 400 | 40 | 0.5 | 0.7 | 42.9 |
| Ex. | 115 | 27 | 250 | 40 | 60.0 | 20.0 | 50.0 |
| Ex. | 116 | 28 | 100 | 40 | 94.2 | 11.1 | 1.9 |
| Ex. | 117 | 29 | 150 | 40 | 2.0 | 2.2 | 1.1 |
| Ex. | 118 | 30 | 50 | 40 | 131.8 | 20.0 | 5.0 |
| Ex. | 119 | 31 | 100 | 40 | 46.7 | 26.7 | 6.7 |
| Ex. | 120 | 32 | 400 | 40 | 1.5 | 2.0 | 5.0 |
| Ex. | 121 | 33 | 250 | 40 | 3.5 | 1.3 | 1.3 |
| Ex. | 122 | 34 | 10000 | 40 | 0.2 | 0.3 | 1.3 |

**Table 12-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 107 | 19 | 0.91 | B | B | A |
| Ex. | 108 | 20 | 0.78 | A | A | A |
| Ex. | 109 | 21 | 0.87 | B | B | A |
| Ex. | 110 | 22 | 0.82 | B | B | A |
| Ex. | 111 | 23 | 0.88 | B | B | A |
| Ex. | 112 | 24 | 0.77 | B | B | A |
| Ex. | 113 | 25 | 0.73 | B | B | A |
| Ex. | 114 | 26 | 0.99 | B | B | B |
| Ex. | 115 | 27 | 0.73 | B | B | A |
| Ex. | 116 | 28 | 0.79 | B | B | A |
| Ex. | 117 | 29 | 0.89 | B | B | A |
| Ex. | 118 | 30 | 0.91 | A | B | A |
| Ex. | 119 | 31 | 0.87 | B | B | A |
| Ex. | 120 | 32 | 0.89 | B | B | A |
| Ex. | 121 | 33 | 0.74 | B | B | A |
| Ex. | 122 | 34 | 0.86 | B | B | B |

**Table 13-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 123 | 35 | 1000 | 40 | 75.3 | 16.0 | 5.0 |
| Ex. | 124 | 36 | 300 | 40 | 71.6 | 23.9 | 1.5 |
| Ex. | 125 | 37 | 300 | 40 | 25.0 | 14.3 | 3.6 |
| Ex. | 126 | 38 | 150 | 40 | 0.2 | 0.3 | 1.5 |
| Ex. | 127 | 39 | 1000 | 40 | 7.8 | 0.8 | 50.0 |
| Ex. | 128 | 40 | 500 | 40 | 36.7 | 39.0 | 2.4 |
| Ex. | 129 | 41 | 100 | 40 | 60.0 | 20.0 | 50.0 |
| Ex. | 130 | 42 | 300 | 40 | 0.2 | 0.3 | 50.0 |
| Ex. | 131 | 43 | 150 | 40 | 9.4 | 10.0 | 5.0 |
| Ex. | 132 | 44 | 50 | 40 | 51.6 | 17.2 | 1.1 |
| Ex. | 133 | 45 | 200 | 40 | 87.2 | 18.5 | 27.8 |
| Ex. | 134 | 46 | 300 | 40 | 480.0 | 160.0 | 5.0 |
| Ex. | 135 | 47 | 50 | 40 | 0.2 | 0.3 | 50.0 |
| Ex. | 136 | 48 | 200 | 40 | 0.3 | 0.4 | 27.8 |
| Ex. | 137 | 49 | 250 | 40 | 1.5 | 2.0 | 5.0 |
| Ex. | 138 | 50 | 50 | 40 | 188.3 | 40.0 | 80.0 |

**Table 13-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 123 | 35 | 0.90 | A | B | A |
| Ex. | 124 | 36 | 0.82 | B | B | A |
| Ex. | 125 | 37 | 0.82 | B | B | A |
| Ex. | 126 | 38 | 0.87 | A | A | B |
| Ex. | 127 | 39 | 0.90 | B | B | B |
| Ex. | 128 | 40 | 0.77 | B | B | A |
| Ex. | 129 | 41 | 0.77 | A | A | A |
| Ex. | 130 | 42 | 0.77 | B | B | B |
| Ex. | 131 | 43 | 0.85 | B | B | A |
| Ex. | 132 | 44 | 0.80 | B | B | A |
| Ex. | 133 | 45 | 0.77 | A | A | A |
| Ex. | 134 | 46 | 0.79 | B | B | A |
| Ex. | 135 | 47 | 0.80 | B | B | B |
| Ex. | 136 | 48 | 0.74 | B | B | B |
| Ex. | 137 | 49 | 0.81 | B | B | A |
| Ex. | 138 | 50 | 0.93 | A | A | A |

**Table 14-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 139 | 19 | 200 | 80 | 56.5 | 20.0 | 50.0 |
| Ex. | 140 | 20 | 500 | 80 | 1.9 | 2.0 | 50.0 |
| Ex. | 141 | 21 | 500 | 80 | 60.0 | 20.0 | 1.3 |
| Ex. | 142 | 22 | 100 | 80 | 480.0 | 160.0 | 5.0 |
| Ex. | 143 | 23 | 300 | 80 | 60.0 | 20.0 | 50.0 |
| Ex. | 144 | 24 | 1000 | 80 | 42.2 | 14.9 | 1.8 |
| Ex. | 145 | 25 | 500 | 80 | 39.6 | 6.0 | 5.0 |
| Ex. | 146 | 26 | 400 | 80 | 0.5 | 0.7 | 42.9 |
| Ex. | 147 | 27 | 250 | 80 | 60.0 | 20.0 | 50.0 |
| Ex. | 148 | 28 | 100 | 80 | 94.2 | 11.1 | 1.9 |
| Ex. | 149 | 29 | 150 | 80 | 2.0 | 2.2 | 1.1 |
| Ex. | 150 | 30 | 50 | 80 | 131.8 | 20.0 | 5.0 |
| Ex. | 151 | 31 | 100 | 80 | 46.7 | 26.7 | 6.7 |
| Ex. | 152 | 32 | 400 | 80 | 1.5 | 2.0 | 5.0 |
| Ex. | 153 | 33 | 250 | 80 | 3.5 | 1.3 | 1.3 |
| Ex. | 154 | 34 | 10000 | 80 | 0.2 | 0.3 | 1.3 |

**Table 14-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 139 | 19 | 0.73 | B | B | A |
| Ex. | 140 | 20 | 0.78 | A | A | A |
| Ex. | 141 | 21 | 0.78 | B | B | A |
| Ex. | 142 | 22 | 0.78 | B | B | A |
| Ex. | 143 | 23 | 0.86 | B | B | A |
| Ex. | 144 | 24 | 0.74 | B | B | A |
| Ex. | 145 | 25 | 0.90 | B | B | A |
| Ex. | 146 | 26 | 0.85 | B | B | B |
| Ex. | 147 | 27 | 0.87 | B | B | A |
| Ex. | 148 | 28 | 0.91 | B | B | A |
| Ex. | 149 | 29 | 0.95 | B | B | A |
| Ex. | 150 | 30 | 0.79 | A | B | A |
| Ex. | 151 | 31 | 0.91 | B | B | A |
| Ex. | 152 | 32 | 0.78 | B | B | A |
| Ex. | 153 | 33 | 0.94 | B | B | A |
| Ex. | 154 | 34 | 0.94 | B | B | B |

**Table 15-1**

| Category | Chemically Treated Steel Sheet No. | Chemical Treatment Solution No. | Film Deposition Amount (mg/m²) | Drying Temperature (°C) | Ratio of Each Element in Chemically Treated Film (Parts by Mass) | | |
|---|---|---|---|---|---|---|---|
| | | | | | Mo | V | P |
| Ex. | 155 | 35 | 1000 | 80 | 75.3 | 16.0 | 5.0 |
| Ex. | 156 | 36 | 300 | 80 | 71.6 | 23.9 | 1.5 |
| Ex. | 157 | 37 | 300 | 80 | 25.0 | 14.3 | 3.6 |
| Ex. | 158 | 38 | 150 | 80 | 0.2 | 0.3 | 1.5 |
| Ex. | 159 | 39 | 1000 | 80 | 7.8 | 0.8 | 50.0 |
| Ex. | 160 | 40 | 500 | 80 | 36.7 | 39.0 | 2.4 |
| Ex. | 161 | 41 | 100 | 80 | 60.0 | 20.0 | 50.0 |
| Ex. | 162 | 42 | 300 | 80 | 0.2 | 0.3 | 50.0 |
| Ex. | 163 | 43 | 150 | 80 | 9.4 | 10.0 | 5.0 |
| Ex. | 164 | 44 | 50 | 80 | 51.6 | 17.2 | 1.1 |
| Ex. | 165 | 45 | 200 | 80 | 87.2 | 18.5 | 27.8 |
| Ex. | 166 | 46 | 300 | 80 | 480.0 | 160.0 | 5.0 |
| Ex. | 167 | 47 | 50 | 80 | 0.2 | 0.3 | 50.0 |
| Ex. | 168 | 48 | 200 | 80 | 0.3 | 0.4 | 27.8 |
| Ex. | 169 | 49 | 250 | 80 | 1.5 | 2.0 | 5.0 |
| Ex. | 170 | 50 | 50 | 80 | 188.3 | 40.0 | 80.0 |

**Table 15-2**

| Category | Chemically Treated Steel Sheet No. | Chemical Treatment Solution No. | Evaluation Results | | | |
|---|---|---|---|---|---|---|
| | | | V⁵⁺ Percentage | Corrosion Resistance | | Blackening Resistance |
| | | | | Flat Part | Worked Part | |
| Ex. | 155 | 35 | 0.91 | A | B | A |
| Ex. | 156 | 36 | 0.82 | B | B | A |
| Ex. | 157 | 37 | 0.82 | B | B | A |
| Ex. | 158 | 38 | 0.86 | A | A | B |
| Ex. | 159 | 39 | 0.84 | B | B | B |
| Ex. | 160 | 40 | 0.87 | B | B | A |
| Ex. | 161 | 41 | 0.78 | A | A | A |
| Ex. | 162 | 42 | 0.84 | B | B | B |
| Ex. | 163 | 43 | 0.96 | B | B | A |
| Ex. | 164 | 44 | 0.82 | B | B | A |
| Ex. | 165 | 45 | 0.82 | A | A | A |
| Ex. | 166 | 46 | 0.74 | B | B | A |
| Ex. | 167 | 47 | 0.68 | B | B | B |
| Ex. | 168 | 48 | 0.83 | B | B | B |
| Ex. | 169 | 49 | 0.87 | B | B | A |
| Ex. | 170 | 50 | 0.78 | A | A | A |

As is obvious from Tables 12-1, 12-2, 13-1, 13-2, 14-1, 14-2, 15-1, and 15-2, it can be found that all chemically treated steel sheets each having a chemical conversion film in which the percentage of pentavalent vanadium based on mixed-valent vanadium in the chemical conversion film is 0.7 or more, and which includes a first chemical conversion layer containing vanadium, molybdenum and phosphorus, and a second chemical conversion layer disposed on the first chemical conversion layer and containing a group 4A metal oxoate, the chemical conversion film being disposed on the surface of a zinc-based plated steel sheet having a zinc-based plating layer containing 0.1 to 22.0 mass % of aluminum have favorable corrosion resistance and blackening resistance. The chemical conversion film is obtained by applying a chemical treatment solution which contains a water-soluble molybdate, a vanadium salt, an amine, a group 4A metal oxoate, and a phosphate, in which the molar ratio of molybdenum to vanadium is 0.4 to 5.5, and the molar ratio of an amine to vanadium is 0.3 or more to the zinc-based plated steel sheet, followed by drying. The favorable corrosion resistance and blackening resistance of the chemically treated steel sheets are obtained in a wide range of the deposition amount of the chemical conversion film, even when the chemical treatment solution is dried at a relatively low drying temperature.

It can be found, from the above-mentioned results, that the chemically treated steel sheet of the present invention is excellent in worked part corrosion resistance and blackening resistance even when the chemical treatment solution is dried at a low temperature and for a short period of time.

### [Example 4]

### [Preparation of Chemical Treatment Solution No. 51]

Ammonium molybdate, vanadium pentoxide, ethanolamine, ammonium zirconium carbonate (AZC), diammonium hydrogen phosphate, which are shown in Table 1, and water were mixed such that the concentrations are as shown in Tables 16-1 and 16-2 to obtain chemical treatment solution No. 51. The composition and color of each chemical treatment solution are shown in Tables 16-1 and 16-2. In Table 16-2, "Mo/V" indicates the molar ratio of a molybdenum element to a vanadium element, and "amine/V" indicates the molar ratio of an amine to a vanadium element.

### [Preparation of Chemical Treatment Solutions Nos. 52 to 57]

Chemical treatment solutions Nos. 52 to 57 were each obtained in the same manner as chemical treatment solution No. 51 except that molybdenum concentration, the type of the vanadium salt and vanadium concentration, the type and concentration of the amine, zirconium concentration, and the type of the phosphate and phosphate concentration were changed as shown in Tables 16-1 and 16-2.

EDTA and NH in table 1 are not representing an amine and the examples in tables 16-1, 17-1, 18-1 and 19-1 containing NH are reference examples;

P4 and P5 in table 1 are not representing phosphate compounds and the examples in tables 16-2, 17-2, 18-2, 19-2 containing P4 and P5 are reference examples.

**Table 16-1**

| Chemical Treatment Solution No. | M1 | Vanadium Salt | | Amine | | Category |
|---|---|---|---|---|---|---|
| | Mo Conc. (g/L) | Compound | V Conc. (g/L) | Compound | Conc. (g/L) | |
| 51 | 0.075 | V1 | 0.10 | EA | 0.036 | Ex. |
| 52 | 0.075 | V2 | 0.10 | NH | 0.021 | |
| 53 | 24.0 | V2 | 8.00 | EA | 15.3 | |
| 54 | 1.98 | V3 | 0.30 | EA | 1.15 | |
| 55 | 3.11 | V3 | 0.30 | IPA | 1.06 | |
| 56 | 24.0 | V2 | 8.00 | NH | 8.79 | |
| 57 | 14.1 | V2 | 0.30 | EN | 5.75 | |

**Table 16-2**

| Chemical Treatment Solution No. | AZC | Phosphate | | Mo/V (Molar Ratio) | Amine/V (Molar Ratio) | Color of Treatment Solution | Category |
|---|---|---|---|---|---|---|---|
| | Zr Conc. (g/L) | Compound | P Conc. (g/L) | | | | |
| 51 | 5.0 | P1 | 0.25 | 0.40 | 0.30 | Yellow | Ex. |
| 52 | 5.0 | P5 | 0.05 | 0.40 | 0.30 | Yellow | |
| 53 | 40.0 | P4 | 2.00 | 1.59 | 1.60 | Yellow | |
| 54 | 5.0 | P3 | 0.25 | 3.50 | 3.20 | Yellow | |
| 55 | 40.0 | P4 | 20.0 | 5.50 | 2.40 | Yellow | |
| 56 | 46.5 | P2 | 0.50 | 1.59 | 1.60 | Yellow | |
| 57 | 7.5 | P4 | 6.00 | 2.50 | 1.60 | Yellow | |

### [Preparation of Chemical Treatment Solutions Nos. 58 to 64]

Chemical treatment solutions Nos. 58 to 64 were each obtained in the same manner as chemical treatment solutions Nos. 1 to 57 except that an organic resin as a hydrophilic resin is further mixed such that the organic resin has a concentration as shown in Tables 17-1 and 17-2. In Table 17-2, "AR" indicates denotes an acrylic resin, "PO" denotes a polyolefin, "ER" denotes an epoxy resin, and "PU" denotes polyurethane. In addition, the amount of an organic resin in Table 17-2 is the amount (mass %) of an organic resin based on the total amount of vanadium and molybdenum in the chemical treatment solution.

It is noted that "Voncoat 40-418EF" manufactured by DIC Corporation (the "Voncoat" is a registered trademark of this company) was used as "acrylic resin"; "Zaikthene" A type-AC manufactured by Sumitomo Seika Chemicals Co., Ltd. ("Zaikthene" is a registered trademark of this company) was used as "polyolefin"; "Adeka Resin EM-0434AN" manufactured by Adeka Corporation ("Adeka Resin" is a registered trademark of this company) was used as "epoxy resin"; and "Adeka Bontighter HUX-232" manufactured by Adeka Corporation ("Adeka Bontighter" is a registered trademark of this company) was used as "polyurethane."

### [Preparation of Chemical Treatment Solutions Nos. 65 and 66]

Chemical treatment solutions Nos. 65 and 66 were each obtained in the same manner as chemical treatment solution No. 51 except that molybdenum concentration, the type of the vanadium salt and vanadium concentration, the type and concentration of the amine, zirconium concentration, the type of the phosphate and phosphate concentration, and the type and concentration of the organic resin were changed as shown in Tables 17-1 and 17-2.

**Table 17-1**

| Chemical Treatment Solution No. | M1 | Vanadium Salt | | Amine | | AZC | Category |
|---|---|---|---|---|---|---|---|
| | Mo Conc. (g/L) | Compound | V Conc. (g/L) | Compound | Conc. (g/L) | Zr Conc. (g/L) | |
| 58 | 0.075 | V1 | 0.10 | EA | 0.036 | 5.0 | Comp. Ex. |
| 59 | 0.075 | V2 | 0.10 | NH | 0.021 | 5.0 | Comp. Ex. |
| 60 | 24.0 | V2 | 8.00 | EA | 15.3 | 40.0 | Ex. |
| 61 | 1.98 | V3 | 0.30 | EA | 1.15 | 5.0 | Comp. Ex. |
| 62 | 3.11 | V3 | 0.30 | IPA | 1.06 | 40.0 | Ex. |
| 63 | 24.0 | V2 | 8.00 | NH | 8.79 | 46.5 | Ex. |
| 64 | 14.1 | V2 | 0.30 | EN | 5.75 | 7.5 | Comp. Ex. |
| 65 | 1.00 | V1 | 0.30 | IPA | 2.00 | 1.0 | Comp. Ex. |
| 66 | 1.00 | V1 | 0.30 | IPA | 2.00 | 1.0 | Comp. Ex. |

**Table 17-2**

| Chemical Treatment Solution No. | Phosphate | | Organic Resin | | | Mo/V (Molar Ratio) | Amine/V (Molar Ratio) | Color of Treatment Solution | Category |
|---|---|---|---|---|---|---|---|---|---|
| | Compound | P Conc. (g/L) | Compound | Conc. (g/L) | Amount (mass %) | | | | |
| 58 | P1 | 0.25 | AR | 50.0 | 28500 | 0.40 | 0.30 | Yellow | Comp. Ex. |
| 59 | P5 | 0.05 | PO | 80.0 | 45600 | 0.40 | 0.30 | Yellow | Comp. Ex. |
| 60 | P4 | 2.00 | ER | 20.0 | 63.0 | 1.59 | 1.60 | Yellow | Ex. |
| 61 | P3 | 0.25 | AR | 5.00 | 220 | 3.50 | 3.20 | Yellow | Comp. Ex. |
| 62 | P4 | 20.0 | PO | 0.50 | 15.0 | 5.50 | 2.40 | Yellow | Ex. |
| 63 | P2 | 0.50 | ER | 20.0 | 63.0 | 1.59 | 1.60 | Yellow | Ex. |
| 64 | P4 | 6.00 | PU | 200 | 1170 | 2.50 | 1.60 | Yellow | Comp. Ex. |
| 65 | - | - | PU | 200 | 13300 | 0.53 | 2.72 | Yellow | Comp. Ex. |
| 66 | P1 | 1.00 | PU | 200 | 13300 | 0.53 | 2.72 | Yellow | Comp. Ex. |

### [Preparation of Chemical Treatment Solutions Nos. 67 to 73]

Chemical treatment solutions Nos. 67 to 73 were each obtained in the same manner as chemical treatment solutions Nos. 51 to 57 except that a fluorine compound that produces a fluorine ion or a fluorometal ion in water is further mixed such that the fluorine compound has a concentration as shown in Tables 18-1 and 18-2. The amount of a fluorine compound in Table 18-2 is the amount (mass %) of a fluorine element based on the total amount of vanadium and molybdenum in the chemical treatment solution. The fluorine element is derived from a fluorine ion or a fluorometal ion in the chemical treatment solution.

**Table 18-1**

| Chemical Treatment Solution No. | M1 | Vanadium Salt | | Amine | | AZC | Category |
|---|---|---|---|---|---|---|---|
| | Mo Conc. (g/L) | Compound | V Conc. (g/L) | Compound | Conc. (g/L) | Zr Conc. (g/L) | |
| 67 | 0.075 | V1 | 0.10 | EA | 0.036 | 5.0 | Comp. Ex. |
| 68 | 0.075 | V2 | 0.10 | NH | 0.021 | 5.0 | Comp. Ex. |
| 69 | 24.0 | V2 | 8.00 | EA | 15.3 | 40.0 | Ex. |
| 70 | 1.98 | V3 | 0.30 | EA | 1.15 | 5.0 | Ex. |
| 71 | 3.11 | V3 | 0.30 | IPA | 1.06 | 40.0 | Comp. Ex. |
| 72 | 24.0 | V2 | 8.00 | NH | 8.79 | 46.5 | Comp. Ex. |
| 73 | 14.1 | V2 | 0.30 | EN | 5.75 | 7.5 | Comp. Ex. |

**Table 18-2**

| Chemical Treatment Solution No. | Phosphate | | Fluorine Compound | | | Mo/V (Molar Ratio) | Amine/V (Molar Ratio) | Color of Treatment Solution | Category |
|---|---|---|---|---|---|---|---|---|---|
| | Compound | P Conc. (g/L) | Compound | Conc. (g/L) | Amount (mass %) | | | | |
| 67 | P1 | 0.25 | F1 | 2.00 | 373 | 0.40 | 0.30 | Yellow | Comp. Ex. |
| 68 | P5 | 0.05 | F2 | 1.00 | 570 | 0.40 | 0.30 | Yellow | Comp. Ex. |
| 69 | P4 | 2.00 | F3 | 0.50 | 2.00 | 1.59 | 1.60 | Yellow | Ex. |
| 70 | P3 | 0.25 | F1 | 0.50 | 22.0 | 3.50 | 3.20 | Yellow | Ex. |
| 71 | P4 | 20.0 | F2 | 10.0 | 293 | 5.50 | 2.40 | Yellow | Comp. Ex. |
| 72 | P2 | 0.50 | F3 | 50.0 | 156 | 1.59 | 1.60 | Yellow | Comp. Ex. |
| 73 | P4 | 6.00 | F1 | 20.0 | 117 | 2.50 | 1.60 | Yellow | Comp. Ex. |

### [Preparation of Chemical Treatment Solutions Nos. 74 to 80]

Chemical treatment solutions Nos. 74 to 80 were each obtained in the same manner as chemical treatment solutions Nos. 51 to 57 except that a silicon compound that produces a silanol group in water is further mixed such that the silicon compound has a concentration as shown in Tables 19-1 and 19-2. The amount of a silicon compound in Table 19-2 is the amount (mass %) of a silicon element based on the total amount of vanadium and molybdenum in the chemical treatment solution. The silicon element is derived from a silanol group in the chemical treatment solution.

**Table 19-1**

| Chemical Treatment Solution No. | M1 | Vanadium Salt | | Amine | | AZC | Category |
|---|---|---|---|---|---|---|---|
| | Mo Conc. (g/L) | Compound | V Conc. (g/L) | Compound | Conc. (g/L) | Zr Conc. (g/L) | |
| 74 | 0.075 | V1 | 0.10 | EA | 0.036 | 5.00 | Comp. Ex. |
| 75 | 0.075 | V2 | 0.10 | NH | 0.021 | 5.00 | Comp. Ex. |
| 76 | 24.0 | V2 | 8.00 | EA | 15.327 | 40.0 | Ex. |
| 77 | 1.98 | V3 | 0.30 | EA | 1.150 | 5.00 | Comp. Ex. |
| 78 | 3.11 | V3 | 0.30 | IPA | 1.060 | 40.0 | Comp. Ex. |
| 79 | 24.0 | V2 | 8.00 | NH | 8.794 | 46.5 | Ex. |
| 80 | 14.1 | V2 | 0.30 | EN | 5.748 | 7.50 | Comp. Ex. |

**Table 19-2**

| Chemical Treatment Solution No. | Phosphate | | Silicon Compound | | | Mo/V (Molar Ratio) | Amine/V (Molar Ratio) | Color of Treatment Solution | Category |
|---|---|---|---|---|---|---|---|---|---|
| | Compound | P Conc. (g/L) | Compound | Conc. (g/L) | Amount (mass %) | | | | |
| 74 | P1 | 0.25 | S1 | 2.00 | 179 | 0.40 | 0.30 | Yellow | Comp. Ex. |
| 75 | P5 | 0.05 | S2 | 5.00 | 2850 | 0.40 | 0.30 | Yellow | Comp. Ex. |
| 76 | P4 | 2.00 | S3 | 0.20 | 1.00 | 1.59 | 1.60 | Yellow | Ex. |
| 77 | P3 | 0.25 | S1 | 5.00 | 220 | 3.50 | 3.20 | Yellow | Comp. Ex. |
| 78 | P4 | 20.0 | S2 | 8.00 | 235 | 5.50 | 2.40 | Yellow | Comp. Ex. |
| 79 | P2 | 0.50 | S3 | 10.0 | 31.0 | 1.59 | 1.60 | Yellow | Ex. |
| 80 | P4 | 6.00 | S1 | 20.0 | 117 | 2.50 | 1.60 | Yellow | Comp. Ex. |

Note that, in order to prevent vanadium from being reduced in the preparation of the chemical treatment solution, a vanadium salt was added to and dissolved in an aqueous solution having a liquid temperature of 40°C or lower containing an amine. It is considered that, since the color of each chemical treatment solution is yellow, the valence of vanadium contained in each chemical treatment solution is pentavalent (V⁵⁺).

### [Production of Chemically Treated Steel Sheets Nos. 171 to 200]

The surface of the original sheet for chemical treatment was degreased, and dried. Then, chemical treatment solution No. 51 shown in Tables 16-1 and 16-2 was applied to the surface of the original sheet for chemical treatment in the amount of the deposition amount of chemical conversion film shown in Table 20-1, and immediately thereafter heated and dried at a drying temperature of (a temperature of the steel strip of) 40°C for 2 seconds using an automatic discharge type electric hot air oven to form a chemical conversion film. Thus, chemically treated steel sheet No. 171 was produced.

Further, chemical treatment solutions Nos. 52 to 80 were used in place of chemical treatment solution No. 51 to respectively produce chemically treated steel sheets Nos. 172 to 200 in the same manner as chemically treated steel sheets No. 51, except that the chemical treatment solutions were applied to the original sheet for chemical treatment in the deposition amounts shown in Table 20-1 or 21-1, and heated and dried at a drying temperature shown in Table 20-1 or 21-1. Note that the drying time is 6 seconds when the drying temperature is 80°C.

### [Measurement and Evaluation of Chemically Treated Steel Sheets]

For a test specimen cut out from each chemically treated steel sheet, the structure of the chemical conversion film was identified, and the test specimen was subjected to corrosion resistance test and blackening resistance test in the same manner as Example 1.

As a result, it was confirmed, in chemically treated steel sheets categorized in Examples, that the two-layer structure (i.e., first and second chemical conversion layers) similar to chemically treated steel sheet No. 17, for example, contains vanadium, molybdenum and phosphorus in the first chemical conversion layer and a group 4 metal oxoate in the second chemical conversion layer. However, the two-layer structure in the chemical conversion film was not confirmed in chemically treated steel sheets categorized in Comparative Examples.

The type of chemical treatment solutions, deposition amount, drying temperature, the content of molybdenum, vanadium and phosphorus in the chemical conversion film, the percentage of pentavalent vanadium, and various evaluation results are each shown in Tables 20-1, 20-2, 21-1, and 21-2. Note that each content ratio of molybdenum, vanadium and phosphorus indicates parts by mass of each element based on 100 parts by mass of a zirconium element.

**Table 20-1**

| Chemical Treatment Solution No. | Chemical Treatment Solution No. | Deposition Amount (mg/m²) | Drying Temperature (°C) | Ratio of Each Element in Chemically Treated Film (Parts by Mass) | | | Category |
|---|---|---|---|---|---|---|---|
| | | | | Mo | V | P | |
| 171 | 51 | 200 | 40 | 1.5 | 2.0 | 5.0 | Ex. |
| 172 | 52 | 200 | 80 | 1.5 | 2.0 | 1.0 | Ex. |
| 173 | 53 | 200 | 40 | 60.0 | 20.0 | 5.0 | Ex. |
| 174 | 54 | 500 | 40 | 39.6 | 6.0 | 5.0 | Ex. |
| 175 | 55 | 1000 | 40 | 7.8 | 0.8 | 50.0 | Ex. |
| 176 | 56 | 50 | 40 | 51.6 | 17.2 | 1.1 | Ex. |
| 177 | 57 | 50 | 80 | 188.3 | 40.0 | 80.0 | Ex. |
| 178 | 58 | 200 | 40 | 1.5 | 2.0 | 5.0 | Comp. Ex. |
| 179 | 59 | 200 | 80 | 1.5 | 2.0 | 1.0 | Comp. Ex. |
| 180 | 60 | 200 | 40 | 60.0 | 20.0 | 5.0 | Ex. |
| 181 | 61 | 500 | 40 | 39.6 | 6.0 | 5.0 | Comp. Ex. |
| 182 | 62 | 1000 | 40 | 7.8 | 0.8 | 50.0 | Ex. |
| 183 | 63 | 300 | 40 | 480.0 | 160.0 | 5.0 | Ex. |
| 184 | 64 | 50 | 80 | 188.3 | 40.0 | 80.0 | Comp. Ex. |
| 185 | 65 | 200 | 80 | 100.0 | 50.0 | 0.0 | Comp. Ex. |
| 186 | 66 | 200 | 80 | 100.0 | 50.0 | 100.0 | Comp. Ex. |

**Table 20-2**

| Chemical Treatment Solution No. | Chemical Treatment Solution No. | Evaluation Results | | | | Category |
|---|---|---|---|---|---|---|
| | | V⁵⁺/V | Flat Part Corrosion Resistance | Worked Part Corrosion Resistance | Blackening Resistance | |
| 171 | 51 | 0.92 | A | A | A | Ex. |
| 172 | 52 | 0.81 | B | B | A | Ex. |
| 173 | 53 | 0.92 | B | B | A | Ex. |
| 174 | 54 | 0.85 | A | A | A | Ex. |
| 175 | 55 | 0.71 | A | A | A | Ex. |
| 176 | 56 | 0.79 | A | A | A | Ex. |
| 177 | 57 | 0.79 | B | B | A | Ex. |
| 178 | 58 | 0.85 | D | D | C | Comp. Ex. |
| 179 | 59 | 0.71 | D | D | D | Comp. Ex. |
| 180 | 60 | 0.93 | B | B | A | Ex. |
| 181 | 61 | 0.63 | D | D | C | Comp. Ex. |
| 182 | 62 | 0.82 | A | A | A | Ex. |
| 183 | 63 | 0.95 | A | A | A | Ex. |
| 184 | 64 | 0.75 | D | D | D | Comp. Ex. |
| 185 | 65 | 0.72 | D | D | D | Comp. Ex. |
| 186 | 66 | 0.78 | C | D | D | Comp. Ex. |

**Table 21-1**

| Chemically Treated Steel Sheet No. | Chemical Treatment Solution No. | Deposition Amount (mg/m²) | Drying Temperature (°C) | Ratio of Each Element in Chemically Treated Film (Parts by Mass) | | | Category |
|---|---|---|---|---|---|---|---|
| | | | | Mo | V | P | |
| 187 | 67 | 200 | 40 | 1.5 | 2.0 | 5.0 | Comp. Ex. |
| 188 | 68 | 200 | 80 | 1.5 | 2.0 | 1.0 | Comp. Ex. |
| 189 | 69 | 200 | 40 | 60.0 | 20.0 | 5.0 | Ex. |
| 190 | 70 | 500 | 40 | 39.6 | 6.0 | 5.0 | Ex. |
| 191 | 71 | 1000 | 40 | 7.8 | 0.8 | 50.0 | Comp. Ex. |
| 192 | 72 | 300 | 40 | 480.0 | 160.0 | 5.0 | Comp. Ex. |
| 193 | 73 | 50 | 80 | 188.3 | 40.0 | 80.0 | Comp. Ex. |
| 194 | 74 | 200 | 40 | 1.5 | 2.0 | 5.0 | Comp. Ex. |
| 195 | 75 | 200 | 80 | 1.5 | 2.0 | 1.0 | Comp. Ex. |
| 196 | 76 | 200 | 40 | 60.0 | 20.0 | 5.0 | Ex. |
| 197 | 77 | 500 | 40 | 39.6 | 6.0 | 5.0 | Comp. Ex. |
| 198 | 78 | 1000 | 40 | 7.8 | 0.8 | 50.0 | Comp. Ex. |
| 199 | 79 | 300 | 40 | 480.0 | 160.0 | 5.0 | Ex. |
| 200 | 80 | 50 | 80 | 188.3 | 40.0 | 80.0 | Comp. Ex. |

**Table 21-2**

| Chemically Treated Steel Sheet No. | Chemical Treatment Solution No. | Evaluation Results | | | | Category |
|---|---|---|---|---|---|---|
| | | V⁵⁺/V | Flat Part Corrosion Resistance | Worked Part Corrosion Resistance | Blackening Resistance | |
| 187 | 67 | 0.85 | D | D | D | Comp. Ex. |
| 188 | 68 | 0.81 | D | D | D | Comp. Ex. |
| 189 | 69 | 0.92 | B | B | A | Ex. |
| 190 | 70 | 0.90 | A | A | A | Ex. |
| 191 | 71 | 0.68 | D | D | D | Comp. Ex. |
| 192 | 72 | 0.75 | D | D | D | Comp. Ex. |
| 193 | 73 | 0.74 | D | D | D | Comp. Ex. |
| 194 | 74 | 0.81 | C | D | D | Comp. Ex. |
| 195 | 75 | 0.79 | D | D | D | Comp. Ex. |
| 196 | 76 | 0.95 | B | B | A | Ex. |
| 197 | 77 | 0.84 | C | D | D | Comp. Ex. |
| 198 | 78 | 0.76 | C | D | D | Comp. Ex. |
| 199 | 79 | 0.93 | A | A | A | Ex. |
| 200 | 80 | 0.78 | C | D | D | Comp. Ex. |

As is obvious from Tables 16-1, 16-2 and 20-1, 20-2, in chemically treated steel sheets Nos. 171 to 177 obtained using, respectively, chemical treatment solutions Nos. 51 to 57, all of flat part corrosion resistance, worked part corrosion resistance and blackening resistance were sufficiently favorable.

However, as is obvious from Tables 17-1, 17-2 and 20-1, 20-2, in chemically treated steel sheets Nos. 178 to 184 obtained using, respectively, chemical treatment solutions Nos. 58 to 64 having the same compositions as those of chemical treatment solutions Nos. 51 to 57 except containing a hydrophilic resin, at least one of flat part corrosion resistance, worked part corrosion resistance and blackening resistance were insufficient at times. Specifically, in chemically treated steel sheets Nos. 180, 182 and 183 using, respectively, chemical treatment solutions Nos. 60, 62 and 63 having a relatively low concentration of a hydrophilic resin, all of flat part corrosion resistance, worked part corrosion resistance and blackening resistance were sufficiently favorable. In contrast, in chemically treated steel sheets Nos. 178, 179, 181 and 184 obtained using, respectively, chemical treatment solutions Nos. 58, 59, 61 and 64 having a relatively high concentration of a hydrophilic resin, all of flat part corrosion resistance, worked part corrosion resistance and blackening resistance were insufficient. This is considered to be because the content of a hydrophilic resin at a relatively high concentration in a chemical treatment solution inhibits the formation of the two-layer structure in the chemical conversion film.

Also in chemically treated steel sheets Nos. 185 and 186, all of flat part corrosion resistance, worked part corrosion resistance and blackening resistance were insufficient. This is considered as follows: chemical treatment solutions Nos. 65 and 66 contain a hydrophilic resin at a high concentration regardless of the presence/absence of phosphorus even though "Mo/V" and "amine/V" in chemical treatment solutions Nos. 65 and 66 are the same, and thus the formation of the two-layer structure in the chemical conversion film is inhibited for the same reason as described above.

Further, as is obvious from Tables 18-1, 18-2 and 21-1, 21-2, in chemically treated steel sheets Nos. 187 to 193 obtained using, respectively, chemical treatment solutions Nos. 67 to 73 having the same compositions as those of chemical treatment solutions Nos. 51 to 57 except containing fluorine as a fluorine ion or a fluorometal ion, at least one of flat part corrosion resistance, worked part corrosion resistance and blackening resistance were insufficient at times. Specifically, in chemically treated steel sheets Nos. 189 and 190 using, respectively, chemical treatment solutions Nos. 69 and 70 having a relatively low concentration of fluorine, all of flat part corrosion resistance, worked part corrosion resistance and blackening resistance were sufficiently favorable. In contrast, in chemically treated steel sheets Nos. 187, 188, and 191 to 193 obtained using, respectively, chemical treatment solutions Nos. 67, 68, and 71 to 73 having a relatively high concentration of fluorine, all of flat part corrosion resistance, worked part corrosion resistance and blackening resistance were insufficient. This is considered to be because the content of the fluorine at a relatively high concentration in a chemical treatment solution inhibits the formation of the two-layer structure in the chemical conversion film.

Further, as is obvious from Tables 19-1, 19-2 and 21-1, 21-2, in chemically treated steel sheets Nos. 194 to 200 obtained using, respectively, chemical treatment solutions Nos. 74 to 80 having the same compositions as those of chemical treatment solutions Nos. 51 to 57 except containing silicon derived from a silanol group, at least one of flat part corrosion resistance, worked part corrosion resistance and blackening resistance were insufficient at times. Specifically, in chemically treated steel sheets Nos. 196 and 199 using, respectively, chemical treatment solutions Nos. 76 and 79 having a relatively low concentration of silicon, all of flat part corrosion resistance, worked part corrosion resistance and blackening resistance were sufficiently favorable. In contrast, in chemically treated steel sheets Nos. 194, 195, 197, 198, and 200 obtained using, respectively, chemical treatment solutions Nos. 74, 75, 77, 78, and 80 having a relatively high concentration of silicon, all of flat part corrosion resistance, worked part corrosion resistance and blackening resistance were insufficient. This is considered to be because the content of the silicon at a relatively high concentration in a chemical treatment solution inhibits the formation of the two-layer structure in the chemical conversion film.

As described above, it can be found that a chemically treated steel sheet excellent in worked part corrosion resistance and blackening resistance can be obtained by applying, to a zinc-based plated steel sheet having a zinc-based plating layer containing 0.1 to 22.0 mass % of aluminum, a chemical treatment solution containing a water-soluble molybdate, a vanadium salt, an amine, a group 4A metal oxoate and a phosphate compound, in which a molar ratio of molybdenum to vanadium is 0.4 to 5.5, and a molar ratio of the amine to the vanadium is 0.3 or more; and the content of the hydrophilic resin is at most 100 mass %, the fluorine concentration is at most 30 mass %, or the silicon concentration is at most 50 mass %, based on the total amount of the vanadium and the molybdenum, even when the chemical treatment solution is dried at a low temperature and for a short period of time.

This application claims the priority of Japanese Patent Applications No. 2013-235543 filed on November 14, 2013, and Japanese Patent Applications No. 2014-231275 filed on November 14, 2014.

### Industrial Applicability

The chemically treated steel sheet of the present invention is excellent in corrosion resistance and blackening resistance, and is therefore useful for wide applications such as automobiles, building materials, and home electric appliances, for example.

## Claims

1. A chemical treatment solution for coating a zinc-based plated steel sheet having a zinc-based plating layer containing 0.1 to 22.0 mass % of aluminum, the chemical treatment solution comprising:
a molybdenum acid ion;
a pentavalent vanadium ion;
an amine;
an oxoate of group 4 element; and
a compound selected from the group consisting of a diammonium hydrogen phosphate, an ammonium dihydrogen phosphate, and triammonium phosphate,
wherein:
the amine has a molecular weight of 80 or less,
a molar ratio of molybdenum to vanadium in the chemical treatment solution is 0.4 to 5.5,
a molar ratio of the amine to the vanadium in the chemical treatment solution is 0.3 or more,
a content of a hydrophilic resin in the chemical treatment solution is at most 100 mass % based on a total amount of the vanadium and the molybdenum in the chemical treatment solution,
a total content of fluorine derived from a fluorine ion or a fluorometal ion in the chemical treatment solution is at most 30 mass % based on the total amount of the vanadium and the molybdenum in the chemical treatment solution, and
a content of silicon derived from a silanol group in the chemical treatment solution is at most 50 mass % based on the total amount of the vanadium and the molybdenum in the chemical treatment solution.

2. A chemically treated steel sheet, formed by applying the chemical treatment solution according to claim 1 to the surface of a zinc-based plated steel sheet and drying the same, comprising:
the zinc-based plated steel sheet having a zinc-based plating layer containing 0.1 to 22.0 mass % of aluminum, and a chemical conversion film disposed on the zinc-based plating layer,
wherein:
the chemical conversion film includes a first chemical conversion layer disposed on a surface of the zinc-based plating layer and containing vanadium, molybdenum and phosphorus, and a second chemical conversion layer disposed on the first chemical conversion layer and containing an oxoate of group 4 element, and
a percentage of pentavalent vanadium based on mixed-valent vanadium in the chemical conversion film is 0.7 or more.

3. The chemically treated steel sheet according to claim 2, wherein:
the oxoate of group 4 element is a zirconium oxoate, and
the chemical conversion film contains 1 to 60 parts by mass of molybdenum, 2 to 20 parts by mass of vanadium, and 10 to 50 parts by mass of phosphorus, based on 100 parts by mass of zirconium.

4. The chemically treated steel sheet according to claim 2 or 3, wherein the zinc-based plated steel sheet is a hot-dip aluminum- and magnesium-containing zinc plated steel sheet having a hot-dip aluminum- and magnesium-containing zinc plating layer containing 0.1 to 22.0 mass % of aluminum and 1.5 to 10.0 mass % of magnesium.

## Patentansprüche

1. Chemische Behandlungslösung zum Beschichten eines verzinkten Stahlblechs, das eine Überzugsschicht auf Zinkbasis, die 0,1 bis 22,0 Masse-% Aluminium enthält, aufweist, wobei die chemische Behandlungslösung umfasst:
ein Molybdänsäureion;
ein fünfwertiges Vanadiumion;
ein Amin;
ein Oxoat eines Elements der Gruppe 4; und
eine Verbindung, ausgewählt aus der Gruppe bestehend aus einem Diammoniumhydrogenphosphat, einem Ammoniumdihydrogenphosphat und Triammoniumphosphat,
wobei:
das Amin ein Molekulargewicht von 80 oder weniger aufweist,
ein Molverhältnis von Molybdän zu Vanadium in der chemischen Behandlungslösung 0,4 bis 5,5 beträgt,
ein Molverhältnis des Amins zu dem Vanadium in der chemischen Behandlungslösung 0,3 oder mehr beträgt,
ein Gehalt an einem hydrophilen Harz in der chemischen Behandlungslösung höchstens 100 Masse-% beträgt, bezogen auf eine Gesamtmenge des Vanadiums und des Molybdäns in der chemischen Behandlungslösung,
ein Gesamtgehalt an Fluor, das von einem Fluorion oder einem Fluormetallion in der chemischen Behandlungslösung abgeleitet ist, höchstens 30 Masse-% beträgt, bezogen auf die Gesamtmenge des Vanadiums und des Molybdäns in der chemischen Behandlungslösung, und
ein Gehalt an Silizium, das von einer Silanolgruppe in der chemischen Behandlungslösung abgeleitet ist, höchstens 50 Masse-% beträgt, bezogen auf die Gesamtmenge des Vanadiums und des Molybdäns in der chemischen Behandlungslösung.

2. Chemisch behandeltes Stahlblech, ausgebildet durch Aufbringen der chemischen Behandlungslösung nach Anspruch 1 auf die Oberfläche eines verzinkten Stahlblechs und Trocknen desselben, umfassend:
das verzinkte Stahlblech, das eine Überzugsschicht auf Zinkbasis, die 0,1 bis 22,0 Masse-% Aluminium enthält, aufweist, und einen chemischen Umwandlungsfilm, der auf der Überzugsschicht auf Zinkbasis angeordnet ist,
wobei:
der chemische Umwandlungsfilm eine erste chemische Umwandlungsschicht, die auf einer Oberfläche der Überzugsschicht auf Zinkbasis angeordnet ist und Vanadium, Molybdän und Phosphor enthält, und eine zweite chemische Umwandlungsschicht, die auf der ersten chemischen Umwandlungsschicht angeordnet ist und ein Oxoat eines Elements der Gruppe 4 enthält, beinhaltet, und
ein Prozentsatz von fünfwertigem Vanadium auf Grundlage von gemischtwertigem Vanadium in dem chemischen Umwandlungsfilm 0,7 oder mehr beträgt.

3. Chemisch behandeltes Stahlblech nach Anspruch 2, wobei:
das Oxoat des Elements der Gruppe 4 ein Zirkoniumoxoat ist und
der chemische Umwandlungsfilm 1 bis 60 Massenteile Molybdän, 2 bis 20 Massenteile Vanadium und 10 bis 50 Massenteile Phosphor enthält, bezogen auf 100 Massenteile Zirkonium.

4. Chemisch behandeltes Stahlblech nach Anspruch 2 oder 3, wobei das verzinkte Stahlblech ein Aluminium und Magnesium enthaltendes schmelztauchverzinktes Stahlblech ist, das eine Aluminium und Magnesium enthaltende Schmelztauch-Zinküberzugsschicht, die 0,1 bis 22,0 Masse-% Aluminium und 1,5 bis 10,0 Masse-% Magnesium enthält, aufweist.

## Revendications

1. Solution de traitement chimique pour revêtir une tôle d'acier plaquée à base de zinc possédant une couche de placage à base de zinc contenant 0,1 à 22,0 % en masse d'aluminium, la solution de traitement chimique contenant :
un ion d'acide de molybdène ;
un ion de vanadium pentavalent ;
un amine ;
un oxoate d'élément du groupe 4 ; et
un composé sélectionné dans le groupe constitué d'un phosphate d'hydrogène diammonique, d'un dihydrogénophosphate d'ammonium et d'un phosphate de triammonium,
dans laquelle :
l'amine a un poids moléculaire de 80 ou moins,
un rapport molaire du molybdène au vanadium dans la solution de traitement chimique est de 0,4 à 5,5,
un rapport molaire de l'amine au vanadium dans la solution de traitement chimique est de 0,3 ou plus,
une teneur en résine hydrophile dans la solution de traitement chimique est d'au plus 100 % en masse par rapport à une quantité totale de vanadium et de molybdène dans la solution de traitement chimique,
une teneur totale en fluor dérivé d'un ion de fluor ou d'un ion fluorométallique dans la solution de traitement chimique est d'au plus 30 % en masse par rapport à la quantité totale de vanadium et de molybdène dans la solution de traitement chimique, et
une teneur en silicium dérivé d'un groupe silanol dans la solution de traitement chimique est d'au plus 50 % en masse par rapport à la quantité totale de vanadium et de molybdène dans la solution de traitement chimique.

2. Tôle d'acier traitée chimiquement, formée par application de la solution de traitement chimique selon la revendication 1 sur la surface d'une tôle d'acier plaquée à base de zinc et par séchage, comportant :
la tôle d'acier plaquée à base de zinc ayant une couche de plaquage à base de zinc contenant 0,1 à 22,0 % en masse d'aluminium, et un film de conversion chimique disposé sur la couche de plaquage à base de zinc,
dans laquelle :
le film de conversion chimique comprend une première couche de conversion chimique disposée sur une surface de la couche de placage à base de zinc et contenant du vanadium, du molybdène et du phosphore, et une seconde couche de conversion chimique disposée sur la première couche de conversion chimique et contenant un oxoate d'élément du groupe 4, et
un pourcentage de vanadium pentavalent par rapport au vanadium à valence mixte dans le film de conversion chimique est de 0,7 ou plus.

3. Tôle d'acier traitée chimiquement selon la revendication 2, dans laquelle :
l'oxoate d'élément de groupe 4 est un oxoate de zirconium, et
le film de conversion chimique contient 1 à 60 parts de masse de molybdène, 2 à 20 parts de masse de vanadium et 10 à 50 parts de masse de phosphore, pour 100 parts de masse de zirconium.

4. Tôle d'acier traitée chimiquement selon la revendication 2 ou 3, dans laquelle la tôle d'acier plaquée à base de zinc est une tôle d'acier plaquée par immersion à chaud au zinc contenant de l'aluminium et du magnésium, ayant une couche de plaquage par immersion à chaud au zinc contenant de l'aluminium et du magnésium contenant 0,1 à 22,0 % en masse d'aluminium et 1,5 à 10,0 % en masse de magnésium.
